# EUROPEAN PATENT APPLICATION

(11) **EP 2 590 488 A1**
(43) Date of publication of application: **08.05.2013**
(21) Application number: 12816628.7
(22) Date of filing: 24.07.2012
(51) Int. Cl.: H05K 3/40, H01B 13/00, H05K 3/46

(54) **METHOD FOR MANUFACTURING REUSABLE PASTE, REUSABLE PASTE, AND METHOD FOR MANUFACTURING WIRING SUBSTRATE USING REUSABLE PASTE**

(30) Priority: 27.07.2011 JP 2011163976
(71) Applicant: Panasonic Corporation, Osaka 5718501 (JP)
(72) Inventor: HIMORI, Tsuyoshi, Chuo-ku Osaka-shi, Osaka 540-6207 (JP); KATSUMATA, Masaaki, Chuo-ku Osaka-shi, Osaka 540-6207 (JP); KONDOU, Toshikazu, Chuo-ku Osaka-shi, Osaka 540-6207 (JP)
(74) Representative: Vigand, Philippe
(86) International application number: PCT/JP2012/004688
(87) International publication number: WO 2013/014918

(57) **Abstract**

A method of manufacturing a reuse paste includes preparing a fiber piece housing paste, producing a filtered recovery paste, and producing a reuse paste. In the preparing of the fiber piece housing paste, a conductive paste including a conductive particle, resin and a latent curing agent, and a fiber piece housing paste including a fiber piece dropping off from a prepreg used for manufacturing a circuit board are prepared. In the producing of the filtered recovery paste, the filtered recovery paste is produced by filtering the fiber piece housing paste, which remains in a paste state, by using a filter. In the production of the reuse paste, the reuse paste is produced by adding at least one of a solvent, resin, and a paste having a different composition from that of the filtered recovery paste into the filtered recovery paste.

## Description

### TECHNICAL FIELD

The present invention relates to a method of manufacturing a circuit board for connecting wiring patterns formed on both surfaces through a via or a circuit board for connecting layers by a conductive paste, a reuse paste used therefor, and a method of manufacturing the reuse paste.

### BACKGROUND ART

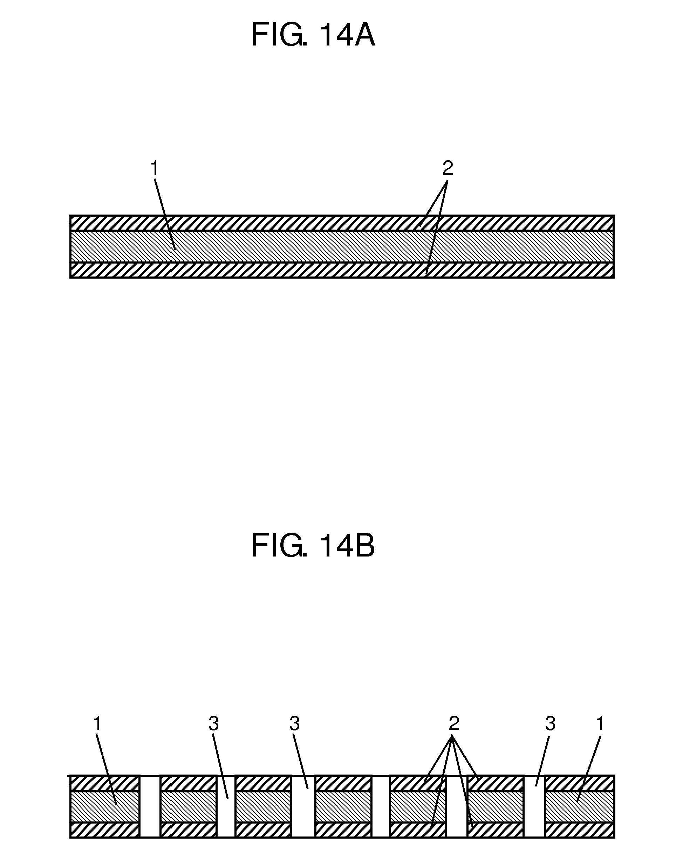

In recent years, with a reduction in a size and an increase in a density of electronic components, a double-sided board or a multilayer board rather than a conventional single-sided board has been frequently used as a circuit board to be provided with electronic components. Furthermore, as a structure of the circuit board, an inner via hole structure is proposed in place of conventionally widely used through-hole processing and plating. The inner via hole structure is provided by a method of connecting layers by using a conductive paste, which enables high density wiring to be carried out. A method of manufacturing a circuit board using such a conductive paste is described with reference to Figs. 14A to 15C. Figs. 14A to 14D are sectional views for illustrating the method of manufacturing the circuit board by using the conductive paste.

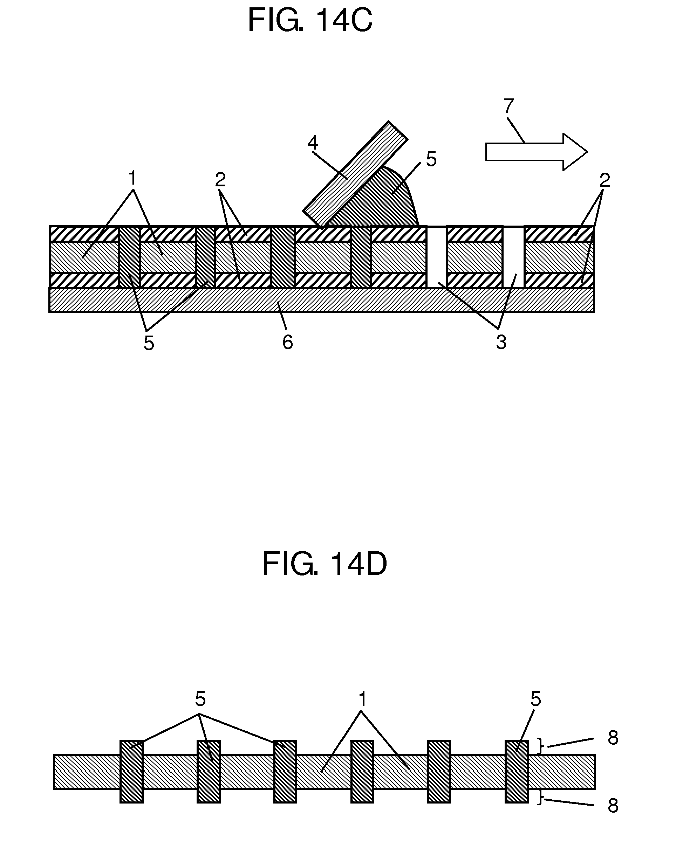

Fig. 14A shows a section of prepreg 1 provided with protective film 2 on both surfaces thereof. Fig. 14B shows a state in which holes 3 are provided in prepreg 1 shown in Fig. 14A. Fig. 14C shows a state in which prepreg 1 having holes 3 is fixed to base 6 and conductive paste 5 is filled in hole 3 by moving jig 4 that is a squeegee made of rubber (or a rubber plate for rubbing) in a direction of arrow 7. Fig. 14D shows a state in which protective film 2 is peeled off from both surfaces of prepreg 1 and protruded portions 8 formed of conductive paste 5 are provided.

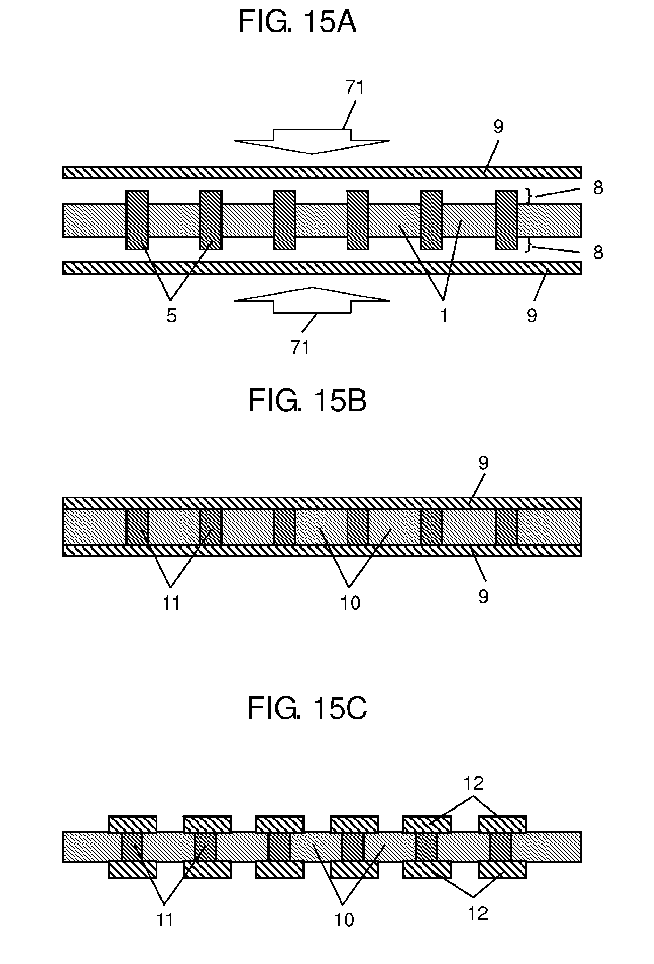

Figs. 15A to 15C are sectional views of steps following Fig. 14D and illustrate a method of manufacturing a double-sided board using conductive paste.

Fig. 15A shows a state in which copper foil 9 is disposed on both surfaces of prepreg 1 provided with protruded portions 8, and pressurization and integration are carried out as shown by arrow 71 by using a press device (not shown). Note here that it is useful that heating is carried out in the integration. When conductive paste 5 is provided with protruded portion 8, conductive powder (conductive particles) included in conductive paste 5 can be compressed and brought into close contact with each other with a high density.

Fig. 15B is a sectional view showing a state after copper foil 9 is integrated through prepreg 1 or conductive paste 5. In Fig. 15B, insulating layer 10 is formed by heating and curing prepreg 1. In via 11, conductive particles included in conductive paste 5 are compressed, deformed, and brought into close contact with each other.

Fig. 15C shows a state in which wiring 12 having predetermined patterns is formed by etching copper foil 9 of Fig. 15B. Thereafter, by forming, for example, a solder resist (not shown), a double-sided board is manufactured.

For prior art literatures regarding the present invention, the following Patent Literatures 1 and 2 are known.

### Patent Literature

PTL 1: Japanese Patent Application Unexamined Publication No. H6-268345
PTL 1: Japanese Patent Application Unexamined Publication No. 2002-171060

### SUMMARY OF THE INVENTION

A method of manufacturing a reuse paste includes preparing a fiber piece housing paste, producing a filtered recovery paste, and producing a reuse paste. In the preparing of the fiber piece housing paste, a conductive paste including a conductive powder, resin and a latent curing agent, and a fiber piece housing paste including a fiber piece dropping off from a prepreg used for manufacturing a circuit board are prepared. In the producing of the filtered recovery paste, the filtered recovery paste is produced by filtering the fiber piece housing paste, which remains in a paste state, by using a filter. In the production of the reuse paste, the reuse paste is produced by adding at least one of a solvent, resin, and a paste having a different composition from that of the filtered recovery paste into the filtered recovery paste.

### BRIEF DESCRIPTION OF DRAWINGS

Fig. 1A is a sectional view for illustrating a state in which a fiber piece attached to a first protective film is recovered in a conductive paste.
Fig. 1B is a sectional view for illustrating a state in which the fiber piece attached to the first protective film is recovered into the conductive paste.
Fig. 1C is a sectional view for illustrating a state in which the fiber piece attached to the first protective film is recovered into the conductive paste.
Fig. 2A is a sectional view for illustrating a state in which the conductive paste is filled in a hole of a first prepreg.
Fig. 2B is a sectional view for illustrating a state in which the conductive paste is filled in the hole of the first prepreg.
Fig. 3A is a sectional view for illustrating an example of a method of manufacturing a circuit board.
Fig. 3B is a sectional view for illustrating an example of the method of manufacturing the circuit board.
Fig. 3C is a sectional view for illustrating an example of the method of manufacturing the circuit board.
Fig. 4A is a sectional view for illustrating a case in which a large number of fiber pieces are mixed in the conductive paste.
Fig. 4B is a sectional view for illustrating a case in which a large number of fiber pieces are mixed in the conductive paste.
Fig. 5A is a sectional view for illustrating a case in which a via made of the conductive paste has an unfilled portion or an air gap.
Fig. 5B is a sectional view for illustrating a case in which the via made of the conductive paste has the unfilled portion or the air gap.
Fig. 5C is a sectional view for illustrating a case in which the via made of the conductive paste has the unfilled portion or the air gap.
Fig. 6 is a schematic view for illustrating a state in which a paste, which has been conventionally discarded, is reproduced as a reuse paste.
Fig. 7 is a schematic view for illustrating a state in which a recovered composite paste is filtered to manufacture a filtered recovery paste.
Fig. 8 is a schematic view for illustrating a state in which a solvent or the like is added into the filtered recovery paste to manufacture a reuse paste.
Fig. 9A is a sectional view for illustrating a state in which the reuse paste is filled in a second hole formed in a second prepreg via a second protective film.
Fig. 9B is a sectional view for illustrating a state in which the reuse paste is filled in the second hole formed in the second prepreg via the second protective film.
Fig. 10A is a sectional view for illustrating a state in which a second circuit board is manufactured by using the reuse paste.
Fig. 10B is a sectional view for illustrating the state in which the second circuit board is manufactured by using the reuse paste.
Fig. 10C is a sectional view for illustrating the state in which the second circuit board is manufactured by using the reuse paste.
Fig. 11A is a view for illustrating a method of manufacturing a multilayer board having four wiring layers.
Fig. 11B is a view for illustrating the method of manufacturing the multilayer board having four wiring layers.
Fig. 11C is a view for illustrating the method of manufacturing the multilayer board having four wiring layers.
Fig. 12A is a view showing an SEM observation image of the recovery paste.
Fig. 12B is a schematic view of Fig. 12A.
Fig. 13A is a schematic view for illustrating an experiment example of a conductive paste as a comparative example.
Fig. 13B is a schematic view for illustrating the experiment example of the conductive paste as the comparative example.
Fig. 13C is a schematic view for illustrating the experiment example of the conductive paste as the comparative example.
Fig. 14A is a sectional view for illustrating a conventional method of manufacturing a circuit board by using a conductive paste.
Fig. 14B is a sectional view for illustrating the conventional method of manufacturing the circuit board by using the conductive paste.
Fig. 14C is a sectional view for illustrating the conventional method of manufacturing the circuit board by using the conductive paste.
Fig. 14D is a sectional view for illustrating the conventional method of manufacturing the circuit board by using the conductive paste.
Fig. 15A is a sectional view of a process following Fig. 14D, illustrating the conventional method of manufacturing a double-sided board by using the conductive paste.
Fig. 15B is a sectional view for illustrating the conventional method of manufacturing the double-sided board by using the conductive paste.
Fig. 15C is a sectional view for illustrating the conventional method of manufacturing the double-sided board by using the conductive paste.

### DESCRIPTION OF EMBODIMENTS

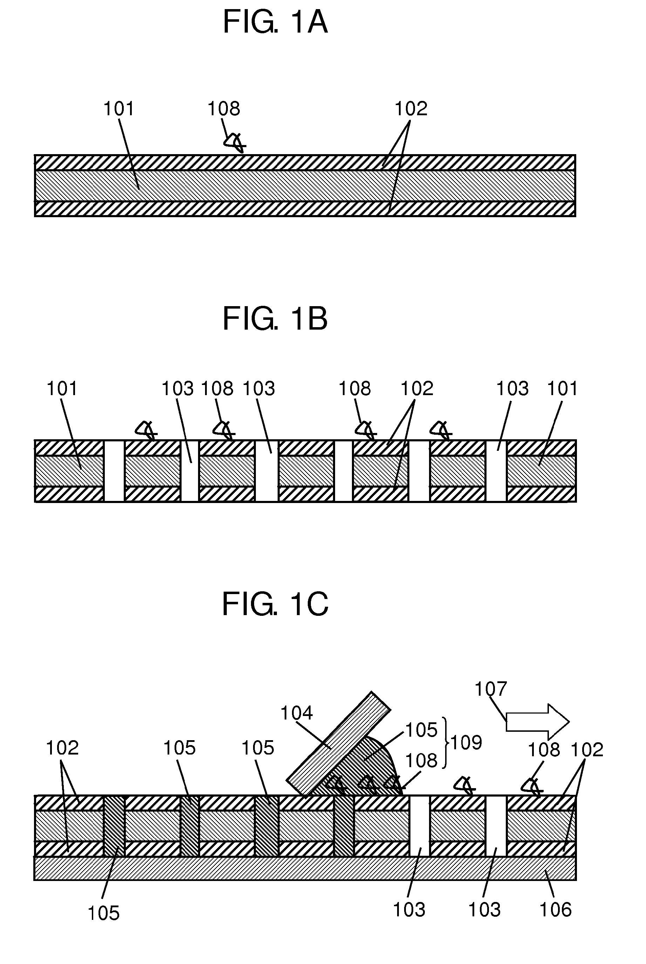

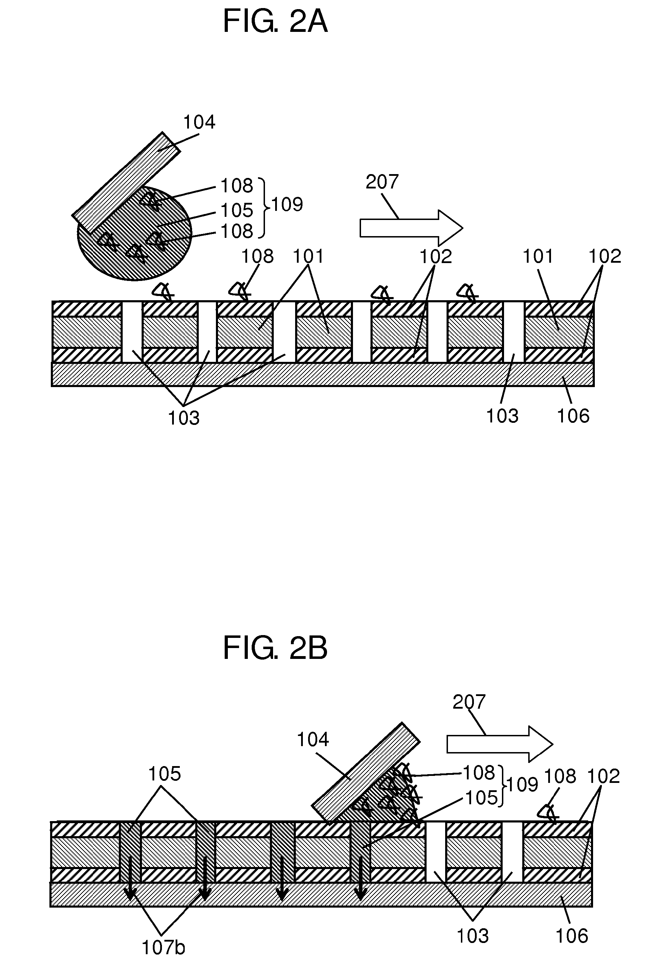

Figs. 1A to 1C, 2A and 2B are sectional views for illustrating a state in which a fiber piece made of a part of glass fibers or resin fibers attached to a protective film is recovered into a conductive paste.

Figs. 1A to 1C are sectional views for illustrating a state in which a fiber piece including glass fibers and resin fibers such as aramid fibers attached to a first protective film is recovered into a conductive paste. First prepreg 101 is formed in a semi-cured state (that is, a B-stage state) by impregnating a glass woven fabric, a glass nonwoven fabric, an aramid woven fabric and an aramid nonwoven fabric with epoxy resin or the like. First protective film 102 is, for example, a PET film. First protective film 102 specifically uses PET (polyethylene terephthalate), PEN (polyethylene naphthalate), PPS (polyphenylene sulfide), or the like. First protective film 102 is formed on the surface of first prepreg 101 by thermocompression while air is removed by using a vacuum laminator or a roller laminator. First hole 103 is formed by, for example, carbon dioxide gas laser and YAG laser, or the like. Furthermore, when large first hole 103 is formed, a drill or a punch may be used. Jig 104 is, for example, a squeegee rubber.

Conductive paste 105 includes a conductive powder (conductive particle), resin as a main agent, and a latent curing agent. As the conductive powder, for example, copper powder having an average particle diameter of not less than 0.5 µm and not more than 20 µm and a specific surface area of not less than 0.1 m²/g and not more than 1.5 m²/g is used. As the main agent, for example, liquid epoxy resin is used. As the curing agent, for example, a latent curing agent is used. Use of the latent curing agent enables stable storage at an ordinary temperature to be carried out and variation during manufacture to be suppressed. It is preferable that a particle diameter of the latent curing agent is not less than 0.5 µm and not more than 30 µm. When the particle diameter is more than 30 µm, an unreacted latent curing agent may remain. When the particle diameter of the latent curing agent is less than 0.5 µm, curing may proceed at once, and the latent curing agent may be removed at the time when the paste is filtered by using the below-mentioned filter. Furthermore, it is preferable that a solid latent curing agent is used because, in the case of a liquid latent curing agent, the ratio of the latent curing agent and the resin as the main agent may largely vary when printing is repeated. As the latent curing agent, an amine-based latent curing agent, an amine adduct-based latent curing agent, a hydrazide-based latent curing agent, an imidazole-based latent curing agent, a dicyandiamide (DICY)-based latent curing agent, or a complex thereof are used.

Conductive paste 105 includes not less than 80 wt.% and not more than 92 wt.% of conductive powder, not less than 4.5 wt.% and not more than 17 wt.% of main agent, and not less than 0.5 wt.% and not more than 5 wt.% of latent curing agent.

Conductive powder 105 may be silver powder, alloy powder, solder powder, Ag-coated powder, or a mixture thereof, having an average particle diameter of not less than 0.5 µm and not more than 20 µm.

Fiber piece 108 is a foreign substance, which drops off from a cut surface of first prepreg 101, has semi-cured epoxy resin attached thereto, and is formed of a glass fiber or a fiber such as aramid, and may be a fiber piece group to which a plurality of fiber pieces are bound with resin.

In Fig. 1A, first protective film 102 is applied to both surfaces of first prepreg 101. Fiber piece 108 is attached to a surface of first protective film 102. When a plurality of first prepregs 101 are stacked in a thickness direction, fiber piece 108 is attached to the surface of each of first prepregs 101 by static electricity or the like. Even if fiber piece 108 is removed by a suction device and an adhesive roll (neither of which are shown in the drawing), new fiber piece 108 is attached to the surface of first prepreg 101 with static electricity generated when a plurality of first prepregs 101 or the like are stacked in the thickness direction or when they are individually peeled therefrom or when friction occurs in handling, for example, in delivery or the like. Thus, even after fiber piece 108 is removed by the suction device or the adhesive roll, new semi-cured epoxy resin or fiber piece 108 drops off from the side surface of the prepreg or the like, and is attached, as a foreign substance, to first protective film 102 formed on the both surfaces of first prepreg 101 with static electricity or the like. For this reason, a countermeasure against the static electricity is required to be taken every process in a manufacturing process of the circuit board. Furthermore, even when the static electricity of first protective film 102 is removed by an electrostatic blower or the like, first protective film 102 is newly charged with static electricity in handling of a next process, or stacking or individual peeling.

Fig. 1B shows a state in which first protective film 102 and first holes 103 are formed with respect to first prepreg 101. First hole 103 may be a through hole as shown in the drawing, but may be a bottomed hole (not shown) depending on uses. In processing of first hole 103 of first prepreg 101, or delivery of a base material which is accompanied by the processing, or handling, new fiber piece 108 may be attached to the surface of first protective film 102.

Fig. 1C shows a state in which conductive paste 105 is filled in first holes 103 by moving jig 104 in a direction shown by arrow 107 on first protective film 102 having fiber piece 108 attached thereto. By increasing a pressure of jig 104 against first protective film 102, pushing power of conductive paste 105 to first hole 103 can be increased. Furthermore, fiber pieces 108 on first protective film 102 can be housed in conductive paste 105 to form fiber piece housing paste 109. Furthermore, even with fiber piece housing paste 109 housing fiber pieces 108 in a small amount, it is possible to push conductive paste 105 into first hole 103 by increasing the pressure of jig 104 against first protective film 102 shown in Fig. 1C. At this time, since a conductive powder and a solid latent curing agent strongly rub each other on the surface of protective film 102, an aggregate of the conductive powder and the latent curing agent may be generated.

It is desirable that jig 104 should be pushed by a predetermined pressure or more so as to be brought into close contact with the surface of first protective film 102. By setting the pressure of jig 104 to be the predetermined pressure or more, an amount of conductive paste 105 (not shown) that is left as a residue on the surface of first protective film 102 can be reduced. As a result, it is possible to reduce conductive paste 105 to be discarded in a state in which it is attached to first protective film 102.

In order to reduce the amount of conductive paste 105 to be discarded in a state in which it is attached to the surface of first protective film 102, it is desirable that conductive particles included in conductive paste 105 should be properly scraped out such that they are not left on the surface of first protective film 102. Herein, as the conductive particle, for example, a copper particle having a particle diameter of about 1 µm to 10 µm is used. As the scraping is carried out more certainly on first protective film 102 by using jig 104, fiber pieces 108 attached to first protective film 102 are housed in conductive paste 105. Hereinafter, the diameter of fiber piece 108 may be not less than 1 µm and furthermore, not less than 5 µm, or may be equal to or larger than the particle diameter of copper particle.

Figs. 2A and 2B are sectional views for illustrating a state in which conductive paste 105 is filled in first holes 103 of first prepreg 101. Fiber pieces 108 are housed in conductive paste 105 to be filled into first holes 103 by using jig 104, so that fiber piece housing paste 109 is formed.

As shown in Fig. 2B, jig 104 is moved in a direction shown by arrow 207 to fill first holes 103 with conductive paste 105. In Fig. 2B, it is useful that conductive paste 105 is vacuum-sucked from base 106 side as shown by arrow 107b. When an amount of fiber pieces 108 housed in conductive paste 105 is large, a viscosity of fiber piece housing paste 109 is increased. As a result, the filling of conductive paste 105 in first holes 103 in Fig. 2B may be influenced. In such cases, base 106 is provided with a vacuum sucking hole or the like to suck conductive paste 105 into first prepreg 101 via a breathable sheet (for example, paper) as shown by arrow 107b, so that a filling property thereof can be enhanced.

When a member having a selective permeability with respect to components of conductive paste 105 is used as the breathable sheet, only a part of the components of conductive paste 105 may be selectively absorbed through the breathable sheet. Therefore, the composition of fiber piece housing paste 109 may be influenced. Herein, examples of the components of conductive paste 105 include a liquid component or a solvent component. The composition of fiber piece housing paste 109 includes, for example, a ratio of a solid content or a liquid component.

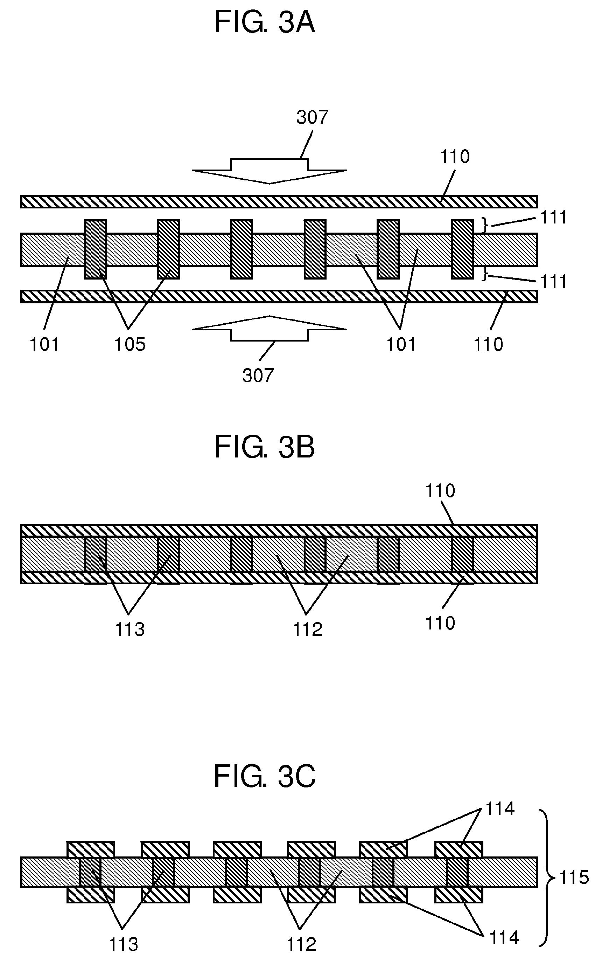

Figs. 3A to 3C are sectional views for illustrating an example of the method of manufacturing a circuit board, showing an example of a process following the manufacturing method of Fig. 2B.

Fig. 3A is a sectional view for showing a state in which first copper foil 110 as metal foil is laminated on the both surfaces of first prepreg 101 provided with first protruded portions 111 formed by conductive paste 105. By adjusting a thickness of first protective film 102 in Figs. 2A, 2B, or the like, a thickness of first protruded portion 111 can be increased and reduced. First copper foil 110 is disposed on both surfaces of first prepreg 101 having first protruded portions 111, which is subjected to pressurization and integration as shown by arrow 307 by using a press device (not shown). In the integration, it is also useful to carry out heating. By providing protruded portion 111 on conductive paste 105, conductive powders included in conductive paste 105 can be pressurized and brought into contact with each other with a high density.

Fig. 3B is a sectional view for illustrating a state after the lamination. First insulating layer 112 is a product obtained by curing first prepreg 101. First via 113 is a product obtained by curing conductive paste 105. First via 113 is strongly pressurized and compressed by a thickness corresponding to that of first protruded portion 111. For this reason, conductive powders such as copper powders included in conductive paste 105 are deformed and brought into face contact with each other. As a result, the via part has a low resistance.

In Fig. 3C, first wiring 114 is formed by patterning first copper foil 110 into a predetermined shape. First circuit board 115 includes first insulating layer 112, first wirings 114 fixed to the both surfaces of first insulating layer 112, and first via 113 for connecting first wirings 114.

By laminating an insulating layer, a wiring or the like on the both surfaces with first circuit board 115 as a core substrate, a multilayer structure can be formed.

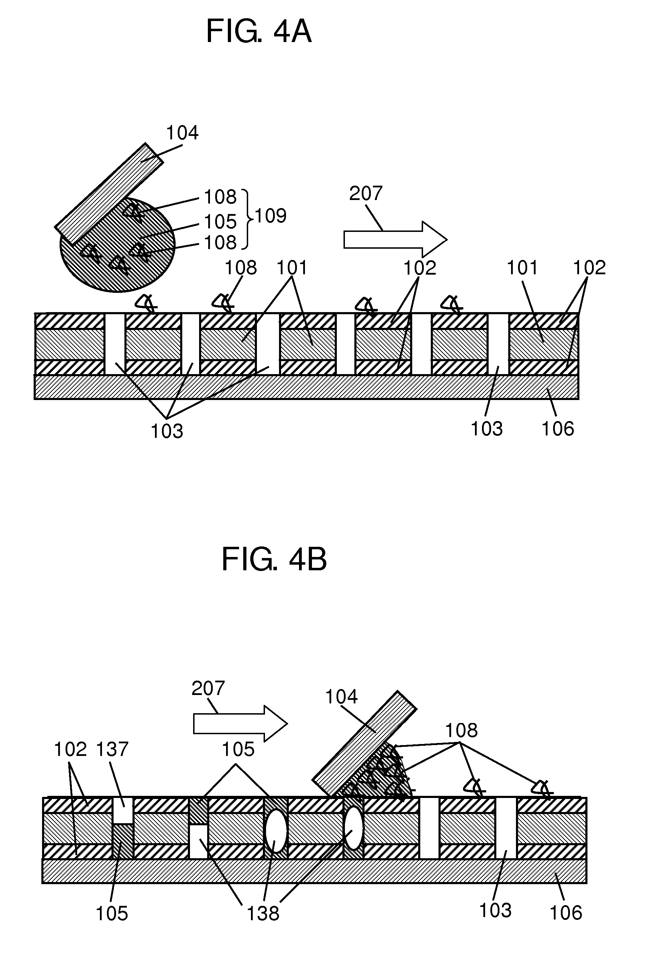

Figs. 4A and 4B are sectional views for illustrating a case in which a large number of fiber pieces 108 are mixed into conductive paste 105. In Fig. 4A, a large number of fiber pieces 108 are mixed into conductive paste 105. Fiber pieces 108 are increased on an integration basis every time squeezing is carried out on first protective film 102 by using jig 104 to which conductive paste 105 is attached. A part of fiber pieces 108, which is attached to the surface of first protective film 102 in the filling of conductive paste 105, is attached to jig 104. Furthermore, fiber piece 108 that has not been able to be removed in the previous process is attached to the surface of first protective film 102 in which first hole 103 is not filled with conductive paste 105.

Fig. 4B shows a state in which a part of fiber pieces 108 attached to first protective film 102 is further mixed into conductive paste 105 when conductive paste 105 is filled in first holes 103 formed in protective film 102 and prepreg 101. When fiber piece 108 is mixed, a viscosity of conductive paste 105 is increased. Consequently, there is a possibility that a filling property of conductive paste 105 into hole 103 may be influenced, resulting in generation of unfilled portion 137 or air gap 138. In Fig. 4B, unfilled portion 137 indicates an opened insufficient filled portion of conductive paste 105. Air gap 138 indicates a closed insufficient filled portion of conductive paste 105. Furthermore, when new conductive paste 105 is supplied onto unfilled portion 137 by using jig 104, air gap 138 may be generated.

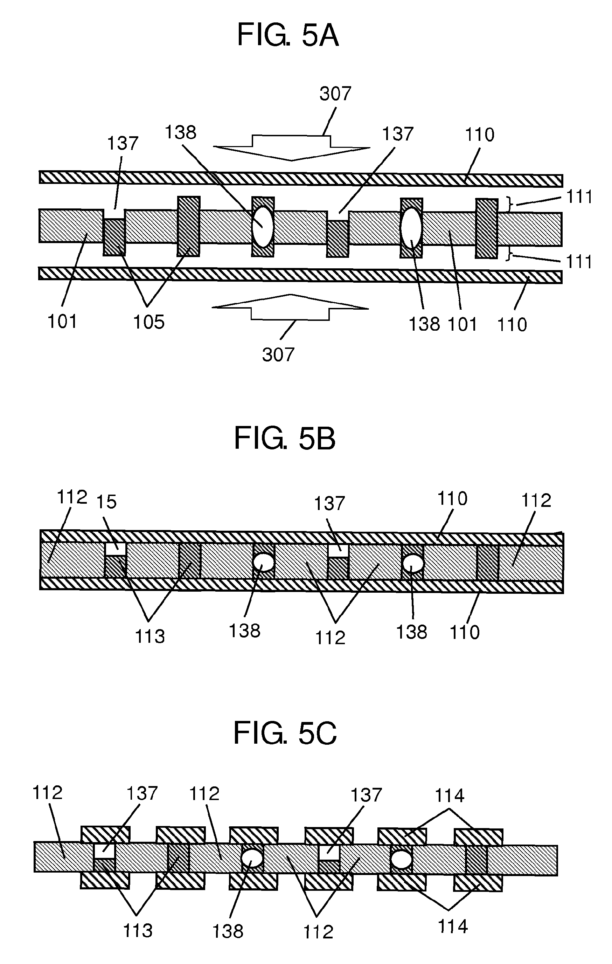

Figs. 5A to 5C are sectional views for illustrating a case in which first via 113 having conductive paste 105 formed therein has unfilled portion 137 and air gap 138. In Fig. 5A, first prepreg 101 is filled with conductive paste 105 in a state that includes unfilled portion 137 or air gap 138. In a case of conductive paste 105 having unfilled portion 137, protrusion of first protruded portion 111 is reduced by a portion of unfilled portion 137. Furthermore, in a case of conductive paste 105 having air gap 138, even if the protrusion of first protruded portion 111 of conductive paste 105 is sufficient, a compression force is reduced by the influence of air gap 138 in pressurization.

Fig. 5B is a sectional view for illustrating an influence of conductive paste 105 including unfilled portion 137 or air gap 138. Fig. 5C is a sectional view for illustrating a state after first copper foil 110 of Fig. 5B is patterned so as to form first wiring 114.

In Figs. 5B and 5C, first insulating layer 112 is obtained by curing prepreg 101, and first via 113 is obtained by curing conductive paste 105. Unfilled portion 137 influences the contact of an interface portion between first via 113 and first copper foil 110. Furthermore, air gap 138 influences the inside of first via 113. There is a possibility that a resistance of first via 113 may be enhanced in each place. That is to say, the compression of conductive paste 105 becomes insufficient, and contact between the conductive powders is deficient, so that a contact resistance is increased.

As mentioned above, when conductive paste 105 is filled in first hole 103 formed in first prepreg 101 through first protective film 102, fiber piece 108 attached to first prepreg 101 is mixed into conductive paste 105, which may influence electrical characteristics. This becomes more remarkable as a diameter of the via becomes smaller.

Such a problem caused by fiber piece 108 hardly arises in a screen printing method which is widely used in manufacture of a circuit board or the like. This is because a screen print (particularly, an emulsion used therein) prevents contact between fiber piece 108 and conductive paste 105 in the screen printing method. Also in a conventional method of manufacturing a circuit board by connecting layers through plating, the problem hardly arises.

As shown in Figs. 1A to 1C, 2A and 2B, when conductive paste 105 is subjected to squeezing (or being rubbed in) on first protective film 102, fiber piece 108 attached to first protective film 102 is mixed into conductive paste 105. Conductive paste 105 having fiber piece 108 mixed therein is formed into fiber piece housing paste 109. When the amount of fiber piece 108 housed in fiber piece housing paste 109 exceeds a predetermined amount, fiber piece 108 is conventionally discarded as waste paste.

Recently, increase in a density of a circuit board and reduction in a diameter of the via have been demanded. The smaller the diameter of the via becomes, the more easily a resistance of the via or the like is influenced by the mixture of the fiber pieces. For this reason, the conductive paste having the fiber piece mixed therein has been discarded.

First prepreg 101 contains a fiber such as glass or aramid and semi-cured resin. Since semi-cured epoxy resin is in an uncured state, it is fragile, small and broken easily. Furthermore, in order to impregnate the fiber with the epoxy resin without generating an air bubble, a fiber-opening processing for disentangling fibers is carried out. Consequently, fiber pieces 108 or semi-cured resin attached to the fiber tends to drop off from a side surface or a cut surface of first prepreg 101.

Furthermore, the dropping resin or fiber piece 108 is easily attached to a surface of other stacked first prepregs 101 with static electricity or the like. This is because first prepreg 101, fiber piece 108, and semi-cured resin are insulating materials and are easily charged with static electricity. Furthermore, several tens of first prepregs 101 (for example, a sheet shape of 500 mm × 600 mm) are stacked in a thickness direction before manufacture, and are peeled off one by one and processed singly during manufacture in many cases. Therefore, first prepreg 101 is easily charged with the static electricity during the stacking or peeling, and fiber pieces 108 or the like dropping off from the side surface of first prepreg 101 are attached to first prepreg 101. Even if fiber piece 108 is removed by, for example, an adhesive roll in a process, new fiber piece 108 may be attached when first prepreg 101 is charged at a next process. Furthermore, even in first prepreg 101 from which static electricity is removed, new static electricity is generated when each of first prepregs 101 is peeled one by one after the lamination.

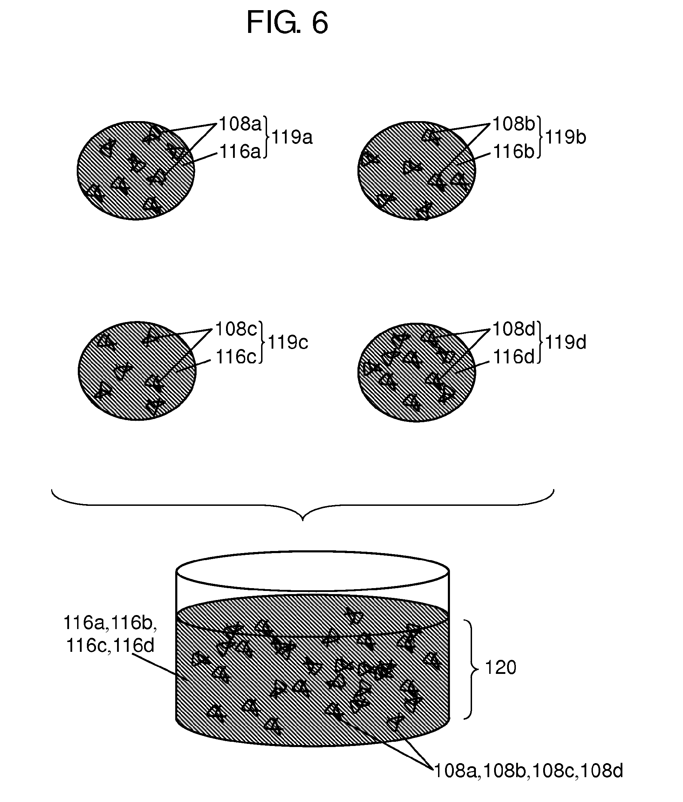

A state in which a waste paste is recycled is described with reference to Figs. 6 to 8.

Fig. 6 is a schematic view for illustrating a state in which a paste that has been conventionally discarded is reused as a reuse paste.

Recovery pastes 119a to 119d are pastes used in separate squeezing processes or separate processes for filling a conductive paste, or used paste attached to separate jig 104, and are conventionally treated as an industrial waste.

Recovery pastes 119a to 119d includes composition deviation pastes 116a to 116d in which composition deviation occurs due to squeezing, or the like and fiber pieces 108a to 108d.

A large number of recovery pastes 119a to 119d are generated in small amounts at the respective processes. Furthermore, in composition deviation pastes 116a to 116d included in recovery pastes 119a to 119d, a composition rate of conductive powder, resin or the like included therein deviates from a standard value in a manufacturing specification. Conductive paste 105 includes conductive powder, a main agent and a latent curing agent. As the number of printing times is increased, the number of fiber pieces 108 in conductive paste 105 is increased, and the amount of the conductive powder is increased. As a result, the composition deviates.

Furthermore, since conductive powders or latent curing agents rub each other by squeezing, an aggregate may be generated. When a latent curing agent as a large aggregate enters the via, it apparently acts as a latent curing agent having a large particle diameter. That is to say, at the time of pressing, an unreacted latent curing agent is left, and this unreacted latent curing agent prevents the contact between the conductive powder in the via. As a result, the resistance value of conductive paste 105 is increased, and the via resistance is increased.

The composition rate is changed according to conditions for squeezing (or conditions for being rubbed), frequency of using paste, or influence of first protective film 102, first hole 103, or the like. Furthermore, types and amounts of fiber pieces 108a to 108d or an aggregate included in recovery pastes 119a to 119d are varied depending on a difference in a type of a base material, an environment, a processing device or a handling device, the number of filling printing, a viscosity of paste, or the like.

A large amount of a plurality of different lots or fiber piece housing paste 109 housing a plurality of fiber pieces obtained in the squeezing process are recovered as a plurality of recovery pastes 119a to 119d. Then, they are gathered into one so as to form recovered composite paste 120.

By recovering a plurality of types of used pastes and unifying them into one so as to form recovered composite paste 120, it is possible to increase an amount of reproduction per time. As a result, a cost of reproduction can be reduced. Note here that recovered composite paste 120 includes various fiber pieces 108a to 108d.

Even if recovery pastes 119a to 119d have different compositions or the like from each other, when they are recovered as a single batch, it is possible to reduce a waste generated in a reproducing process.

Even if recovery pastes 119a to 119d can be recovered in a small amount, for example, about 10 g to 50 g per lot, when a plurality of such small-amount lots are gathered periodically if necessary, recovered composite paste 120 can be made to be not less than 1 kg to 10 kg. As a result, the yield during recycling can be increased, and the process cost can be suppressed. Herein, the plurality of lots mean, for example, 10 to 100 lots or more.

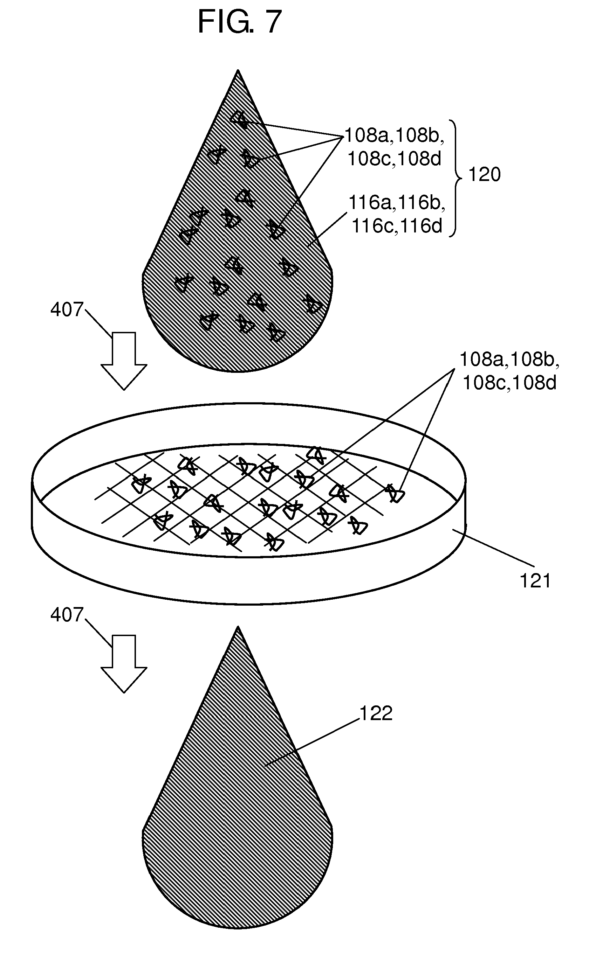

Fig. 7 is a schematic view for illustrating a state in which recovered composite paste 120 is filtered to manufacture filtered recovery paste 122. As filter 121, a mesh formed of stainless, polyester or the like is used. Various fiber pieces 108a to 108d mixed in recovered composite paste 120 are removed by filter 121. That is to say, recovered composite paste 120 is filtered in a direction of arrow 407 so that filtered recovery paste 122 is obtained. At the filtering process, it is possible to increase a filtering speed by using vacuum suction, a rotary push-in blade or a screw, a pressure pump for slurry, a diaphragm pump and the like (which are not shown) together. As the vacuum suction, for example, a vacuum pump, an aspirator for reducing a pressure by the Venturi effect utilizing a fluid, or the like, is used.

It is desirable that an opening diameter of filter 121 should be adjusted in the filtration process of recovered composite paste 120. Specifically, it is desirable that the opening diameter of filter 121 should be not less than three times as large as an average diameter of metal particles included in recovered composite paste 120, and not more than 20 times, further desirably not more than 10 times, and yet further desirably not more than 5 times as large as an average diameter of fibers constituting first prepreg 101. This is because when fibers such as glass fiber are included as a foreign substance in recovered composite paste 120, a length of the glass fiber as the foreign substance is not less than 20 times and further not less than 50 times as great as the average diameter of the glass fiber.

Furthermore, the aggregated conductive powder or the aggregate of the latent curing agent is disentangled by filtration using filter 121. That is to say, since foreign substances are removed and the aggregate is disentangled through a filtration process, filtered recovery paste 122 having a stable resistance value can be obtained.

It is preferable that the opening diameter of filter 121 is not less than three times as large as an average particle diameter of the conductive particles, not more than 20 times as large as an average diameter of fiber pieces 108, and not more than twice as large as the diameter of the latent curing agent.

The latent curing agent is produced by, for example, allowing several types of amines and epoxy resin to react with each other to make them into particles. The latent curing agent can be stored at room temperature for a long time in a state in which the property thereof is not changed, and it is cured when it is heated to a predetermined temperature or higher. When the latent curing agent is used, even if reproduction of conductive paste 105 is carried out many times, more stable printing can be carried out.

It is preferable that the latent curing agent has a softening temperature of not less than 80°C and not more than 180°C. When the softening temperature is less than 80°C, a storage property at ordinary temperature is deteriorated. Furthermore, since a viscosity is increased when it is left at ordinary temperature, conductive paste 105 may not easily enter into the via, and may not be easily filtered. When the softening temperature is more than 180°C, the latent curing agent is not sufficiently melted during pressing, curing of resin as a main agent becomes insufficient, or the latent curing agent that has not been able to be melted remain, and space with which the conductive powder is not brought into contact remains, thus increasing the via resistance in some cases.

By adding a small amount of an organic solvent or the like to recovered composite paste 120 if necessary, a viscosity of recovered composite paste 120 can be lowered. As a result, workability of filtration of filter 121 can be enhanced. Furthermore, it is preferable that the organic solvent or the like, which has been added for filtration, may be appropriately taken out from a solvent or the like to be added later to filtered recovery paste 122 if necessary. In this way, recovered composite paste 120 is filtered in a state in which it remains in a paste state.

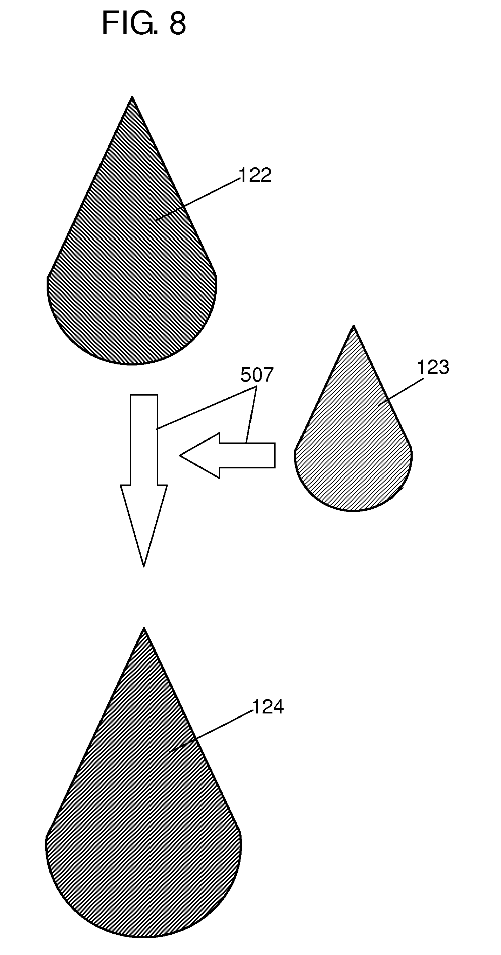

Fig. 8 is a schematic view for illustrating a state in which solvent 123 or the like is added to filtered recovery paste 122 so as to manufacture reuse paste 124.

Solvent 123 or the like is at least any one of a solvent, resin and a paste having a different composition from that of filtered paste. As the solvent, a solvent that is the same solvent as that included in the conductive paste is used. Alternatively, as the solvent, for example, Diethylene glycol monobutyl ether acetate another name of which is Butyl Carbitol Acetate is used. As the resin, resin that is the same as that included in the conductive paste is used. Alternatively, as the resin, epoxy resin or the like is used. Solvent 123 or the like may be added and mixed at one time or separately at a plurality of times. Furthermore, after the viscosity is reduced, filtration is carried out, so that filtered recovery paste 122 may be obtained. Reuse paste 124 is a conductive paste which is reproduced for reuse by removing fiber piece 108 from the used conductive paste without influencing a shape or the like of, for example, copper powder included therein. It is useful to adjust reuse paste 124 to have a composition, a solid content, a viscosity or the like which is substantially the same as that of brand-new conductive paste 105 described in Fig. 1C. However, reuse paste 124 may contain an extremely small fiber piece or the like that is not included in new conductive paste 105. Therefore, it is useful to analyze and specify a difference between conductive paste 105 and reuse paste 124. Specifically, by using TG/DTA, an organic component is allowed to be evaporated, and the content rate of an inorganic component is measured. Then, the measured content rate is compared with the content rate of initial conductive paste 105 so as to calculate a weight of insufficient resin, and resin is added to reuse paste 124. Herein, examples of the "extremely small fiber pieces or the like" include fiber pieces having a length of about one to two times as great as the diameter thereof.

Note here that solvent 123 or the like may be not only an organic solvent but also liquid thermosetting resin or other conductive pastes. When a conductive paste is used as solvent 123 or the like, it is useful to use another conductive paste having a different viscosity and composition ratio from those of conductive paste 105 described in, for example, Fig. 1C. The composition ratio of the conductive paste included in filtered recovery paste 122 largely deviates from a viscosity, a composition ratio or the like, of initial conductive paste 105. In order to correct the deviation, it is desirable to add the other conductive paste having a different viscosity or composition ratio from that of initial conductive paste 105.

It is useful that a kneading device (for example, a planetary mixer or a roll kneading device) is used for mixing filtered recovery paste 122 and solvent 123 or the like.

Herein, it is desirable to use a viscometer for adjusting a viscosity (or measuring the viscosity). Furthermore, it is desirable to use a solid content meter for adjusting a composition ratio (or measuring the composition ratio) or to use a thermal analyzer (which is referred to as DSC, TG, DTA or the like). When conductive powder included in recovery pastes 119a to 119d is base metal (for example, copper), it is useful that the composition ratio is measured and adjusted by thermogravimetry (TG) in a nitrogen atmosphere in order to prevent the influence of oxidation of conductive powder.

Note here that the composition ratio denotes an amount (wt.%) of conductive powder in a paste, an amount (wt.%) of a volatile matter in a paste, an amount (wt.%) of an organic matter in a paste, or the like. Furthermore, since the specific gravity of the paste is largely influenced by a content rate of metal contained in the paste, a specific gravity of the paste may be refereed to. When the specific gravity is measured, a floating method, a specific gravity bottle method, a vibration type density meter, a balance method, or the like, may be used based on JIS K 0061 (Test methods for density and relative density of chemical products). When the pycnometer method is used, a commercially available specific gravity bottle may be used. Herein, a Wadon type, Gay-Lussac type, LeCharite type or JIS K 2249 Harvard type specific gravity bottle is used for measuring specific gravities of liquid and semisolid paving tars having a relatively high viscosity. In the case of a paste having a high viscosity, it is also useful to self-make a specific gravity bottom itself. When a specific gravity bottle having a volume of about 1 cc to 100 cc is self-made, it is useful to use metal materials such as stainless steel. By self-making a specific gravity bottle made of stainless steel, it is possible to prevent damage during measurement or in handling or the like, and facilitating smear washing with a solvent or the like can be carried out easily.

It is useful that fibers each having a length of not less than 10 times as great as an average particle diameter of conductive powders included in fiber piece housing paste 109 occupy not less than 50 wt% in all fiber pieces 108. This is because fibers each having the length of not less than 10 times as great as the average particle diameter of the conductive powders are easily removed in the filtration process. When fibers each having the length of not less than 10 times as great as the average particle diameter of the conductive powders occupy less than 50 wt.% in all fiber pieces 108 included in fiber piece housing paste 109, that is to say, fiber pieces having the length of less than 10 times as great as an average particle diameter of the conductive powders are included in a large amount, the rate of fiber pieces included in reuse paste 124 is increased. That is to say, fiber pieces that have not been able to be removed by filtration are increased. As a result, a property as reuse paste 124 may be influenced.

Furthermore, it is useful that fiber piece housing paste 109 includes not less than 50 wt% and less than 90 wt% of fibers each having the length of not less than 10 times and less than 100 times as great as an average particle diameter of the conductive powders with respect to all fiber pieces 108. When fibers each having a length of not less than 100 times as great as the average particle diameter of the conductive powders are present, or fibers each having a length of not less than 10 times as large as the average particle diameter are present in 90 wt% or more, filtration may be difficult.

Furthermore, by setting fibers included in fiber piece housing paste 109 and having a length of not less than 10 times as great as the average particle diameter of the conductive powders to be not less than 0.01 wt% and not more than 10 wt% with respect to fiber piece housing paste 109, reuse paste 124 can be easily manufactured. When the amount of fibers included in fiber piece housing paste 109 and having the length of not less than 10 times as great as the average particle diameter of the conductive powders is less than 0.01 wt% with respect to fiber piece housing paste 109, a removing effect of long fibers in the filtration process may not be obtained. Furthermore, when it is not less than 10.00 wt%, filtration may be difficult.

It is desirable that fiber piece 108 included in fiber piece housing paste 109 should be a glass fiber or an aramid fiber. Note here that the glass fiber is a part of a glass woven fabric or a glass nonwoven fabric constituting the core material of the prepreg. Furthermore, the aramid fiber is also a part of an aramid fiber or an aramid nonwoven fabric constituting the core material of the prepreg.

Furthermore, it is desirable that an opening diameter of the filter to be used in filtration should be not less than three times as large as an average particle diameter of the conductive powders included in fiber piece housing paste 109, and not more than 20 times as large as the average diameter of fiber pieces 108. When the opening diameter is less than three times as large as the average particle diameter, a filtration effect of the conductive powder may be influenced. Furthermore, when it is more than 20 times as large as the average diameter, a removing property of long fibers may be influenced.

In the filtration process, it is useful to keep a temperature of fiber piece housing paste 109 at a temperature range of not less than 0°C and less than 80°C. When the temperature is less than 0°C, caution is required in handling. When the temperature is not less than 80°C, thermosetting resin included in reuse paste 124 may start to be cured.

In reuse paste 124, it is useful that the rate of fibers each having a length of not less than 10 times as great as an average particle diameter of the conductive powders is made to be not less than 10 wt.% in all fiber pieces. When the rate of long fibers is made to be not more than 10 wt% and furthermore not more than 5 wt%, the increase in a viscosity during the manufacturing process for manufacturing a circuit board by using reuse paste 124 can be reduced.

Furthermore, it is useful to suppress the rate of the fiber pieces having a length of less than three times as large as an average particle diameter of conductive powders included in reuse paste 124 to not more than 5 wt% with respect to the weight of all reuse pastes 124. When the rate is made to be not more than 5 wt%, it is possible to reduce the increase in a viscosity during the manufacturing process when a circuit board is manufactured by using reuse paste 124.

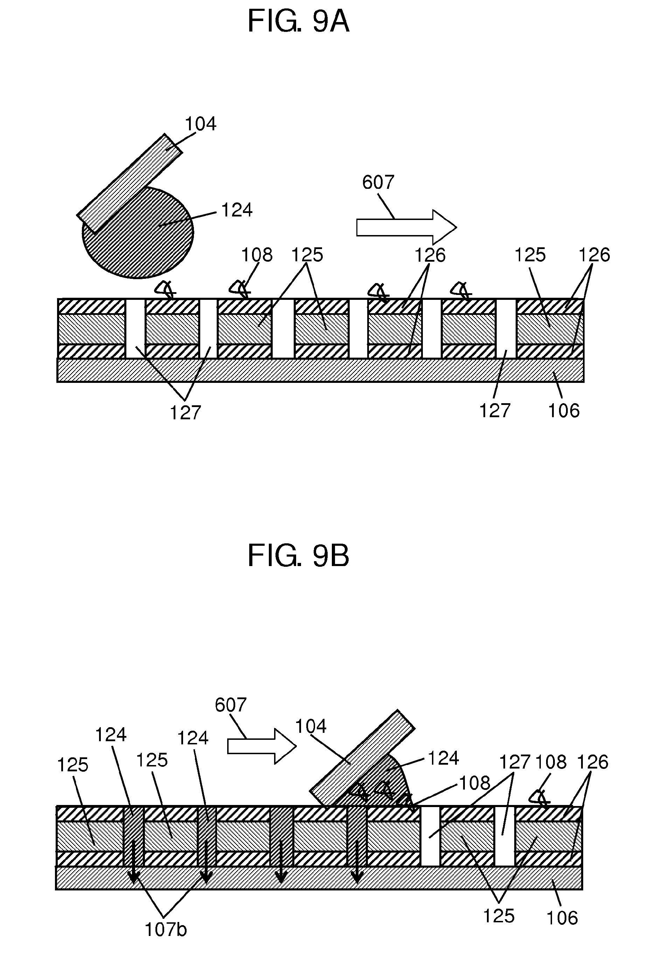

Next, a state in which a second circuit board is manufactured by using reuse paste 124 thus produced is described with reference to Figs. 9A to 11C. The second circuit board uses reuse paste 124 obtained by reproducing, as shown in Figs. 6 to 8, conductive paste 105 used for producing the first circuit board, that is, conductive paste 105 which is conventionally discarded because a large number of fiber pieces 108 are mixed.

Figs. 9A to 11C are sectional views for illustrating the state in which the second circuit board is manufactured by using reuse paste 124.

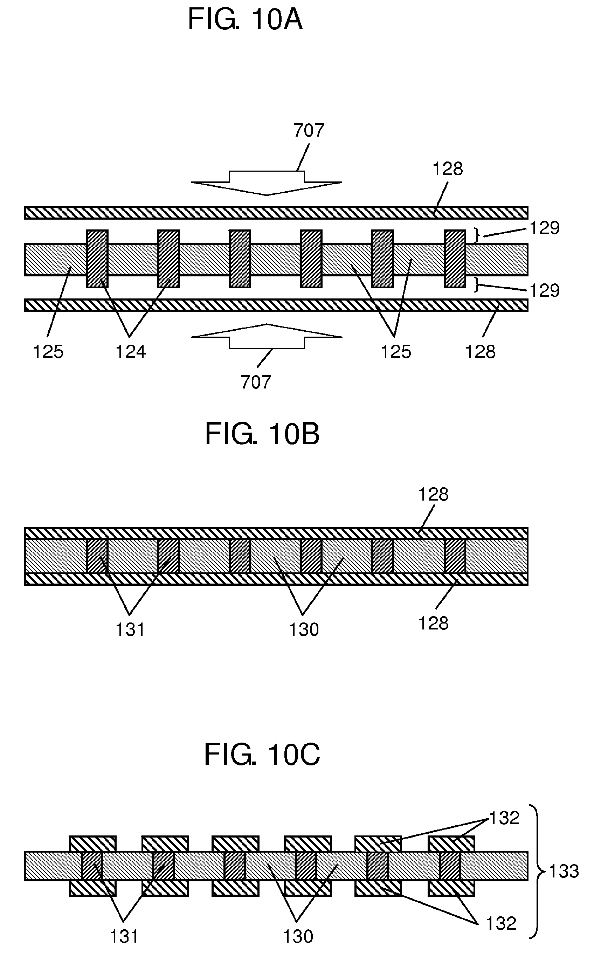

Figs. 9A and 9B are sectional views for illustrating a state in which a reuse paste is filled in second holes 127 formed in second prepreg 125 through the second protective film. In Fig. 9A, second prepreg 125 is formed in a semi-cured state (that is a B-stage state) by impregnating a glass woven fabric, a glass nonwoven fabric, an aramid woven fabric or an aramid nonwoven fabric with epoxy resin. Second protective film 126 is, for example, a PET film. Specific examples of second protective film 126 include PET, PEN, and PPS. Second protective film 126 is formed on the surface of second prepreg 125 by thermocompression by using a vacuum laminator or a roller laminator while air is removed. Second hole 127 can be formed by carbon dioxide gas laser, YAG laser, or the like. Furthermore, when large second hole 127 is formed, a drill or a punch may be used. First prepreg 101 and second prepreg 125 may be the same type of prepreg available from the same manufacturer. First circuit board 115 formed by curing first prepreg 101 is thermally cured before second circuit board 133 (Fig. 10C) formed by curing second prepreg 125 is cured. Reuse paste 124 to be used for first prepreg 101 and second prepreg 125 may be set into an identical lot or different lots. That is to say, the "first" and "second" in first prepreg 101 and second prepreg 125 indicate the order of the processes. In this exemplary embodiment, reuse paste 124 is used for second prepreg 125 to produce second circuit board 133. However, reuse paste 124 may be used for first prepreg 101 to produce first circuit board 115.

Second protective film 126 is applied to both surfaces of second prepreg 125. Fiber pieces 108 such as a glass fiber may be attached to the surface of second protective film 126. Fiber pieces 108 may not be able to be removed by a suction device or an adhesive roll (both are not shown in the drawing).

As shown in Fig. 9B, jig 104 is moved in a direction shown by arrow 607 on second protective film 126 to which fiber pieces 108 are attached so as to fill reuse paste 124 in second hole 127. As shown in Fig. 9B, by strengthening the contact pressure (or a pushing pressure) of jig 104 against second protective film 126, fiber pieces 108 on second protective film 126 can be housed in reuse paste 124. Furthermore, when fiber pieces 108 are housed in reuse paste 124, fiber pieces 108 can be removed as shown in Figs. 6 to 8. As a result, second reuse paste (not shown) or furthermore third reuse paste (not shown) can be produced, so that recycling of the paste can be repeated. By repeating reuse of conductive paste 105 in this way, it is possible to reduce an amount of industrial wastes to be discarded as a waste paste. Therefore, it is possible to take a countermeasure against an environment and to reduce a manufacturing cost. The reuse of conductive paste 105 indicates removing of fiber pieces 108 or the like and readjusting of the composition of conductive paste 105 without influencing a shape or a dispersion state of conductive powder included in conductive paste 105.

Figs. 10A to 10C are sectional views for illustrating a state in which a second circuit board is manufactured by using reuse paste 124. In Fig. 10A, second protruded portion 129 made of reuse paste 124 is formed on second prepreg 125. On both surfaces of second prepreg 125, second copper foil 128 is disposed as metal foil.

When pressurizing (further desirably, heating) is carried out in the direction of arrow 707, a state shown in Fig. 10B is obtained. As shown in Fig. 10B, reuse paste 124 is pressurized and cured to form second via 131, and second prepreg 125 is cured to form second insulating layer 130.

Second copper foil 128 shown in Fig. 10B is formed into a predetermined pattern by etching or the like, so that second wiring 132 in Fig. 10C is obtained. Then, second circuit board 133 is manufactured.

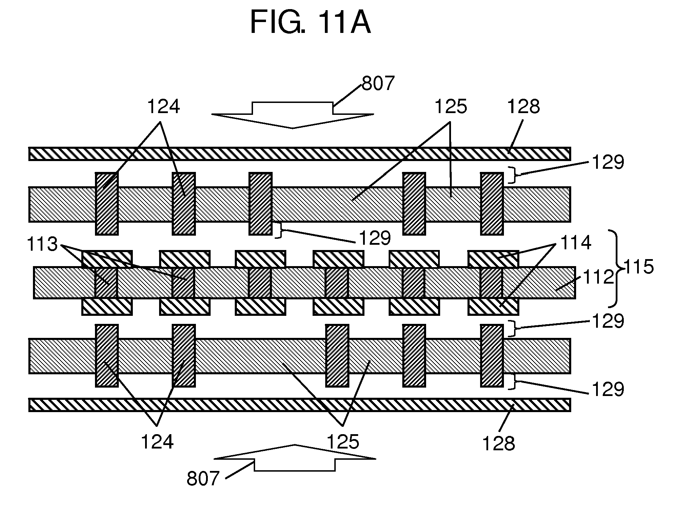

Figs. 11A to 11C are views for illustrating a method of manufacturing a multilayer board having four wiring layers. As shown in Fig. 11A, second prepreg 125 having second protruded portions 129 and second copper foil 128 are set on both surfaces of first circuit board 115, which is subjected to pressurization and integration as shown by arrow in a direction of arrow 807. In the pressurization, heating may be carried out.

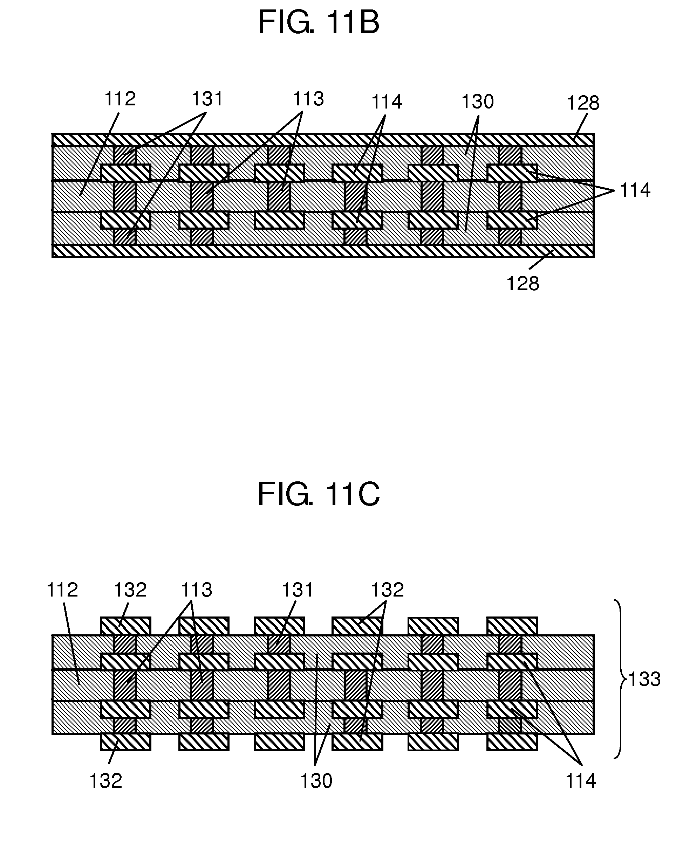

Fig. 11B is a sectional view showing a state in which second prepreg 125 is cured into second insulating layer 130. Thereafter, second copper foil 128 of a surface layer is etched into second wiring 132 so that second circuit board 133 shown in Fig. 11C is obtained. By repeating such processes, it is possible to further make a multilayer.

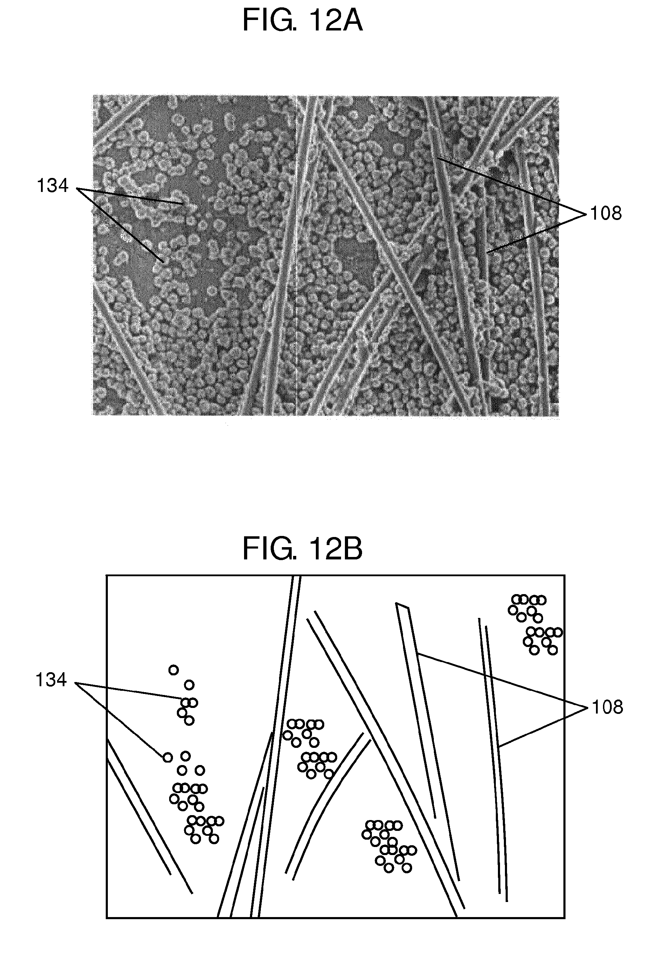

Next, with reference to Figs. 12A and 12B, recovery pastes 119a to 119d are described in more detail by using an SEM observation image.

Figs. 12A and 12B are an SEM observation image of a part of the recovery pastes and a schematic view thereof, respectively. Recovery pastes 119a to 119d include conductive powders 134 made of, for example, copper powder, and fiber pieces 108 made of, for example, a glass fiber.

A particle diameter or a shape of conductive powder 134, a particle size distribution or the like can be optimized depending on respective applications of uses. As shown in Figs. 12A and 12B, a particle diameter of conductive powder 134 is substantially equal to a diameter of fiber piece 108. Furthermore, a length of fiber piece 108 is not less than about 5 times (or not less than 10 times) as great as the diameter thereof. That is to say, fiber piece 108 extends in the length direction with respect to the diameter. Furthermore, particulate conductive powder 134 has a spherical shape whose diameter and length are substantially equal to each other. This exemplary embodiment uses a difference in a shape between fiber piece 108 and of conductive powder 134.

In this exemplary embodiment, waste pastes, which are conventionally discarded, are recovered as recovery pastes 119a to 119d and then gathered into recovered composite paste 120. Then, fiber piece 108 is selectively removed from recovered composite paste 120, and a viscosity or a solid part, a composition ratio, or the like, is adjusted. Then, it is reproduced as a reuse paste. Thus, a circuit board is manufactured.

In this exemplary embodiment, fiber piece housing paste 109, which is generated in processes of Figs. 1A to 3C that are manufacturing processes of first circuit board 115, that is to say, recovery pastes 119a to 119d having fiber pieces 108 mixed therein as shown in Figs. 12A and 12B are reproduced in processes shown in Figs. 6 to 8. Then, it is used as reuse paste 124 in the manufacturing processes of second circuit board 133 as shown in Figs. 9A and 11C.

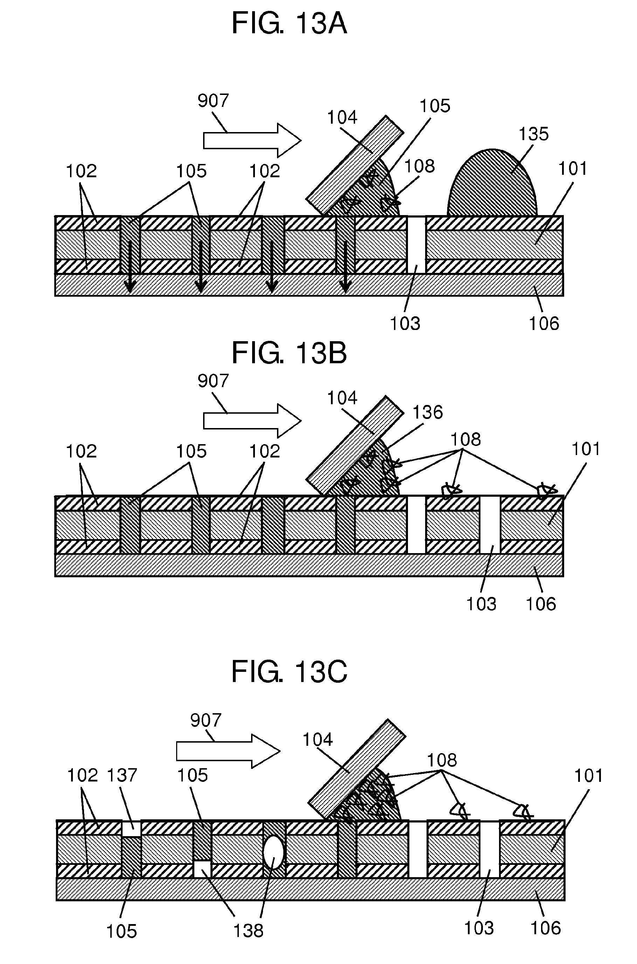

Figs. 13A to 13C are a schematic view for illustrating a state in which a conductive paste is filled as a comparative example. First prepreg 101 having first holes 103 formed therein is fixed to base 106, and jig 104 is moved in a direction of arrow 907 so as to fill conductive paste 105 into first hole 103.

In Fig. 13A, fiber pieces 108 attached to first protective film 102 are mixed into conductive paste 105. As a result, a viscosity of conductive paste 105 is higher than a normalized value in a manufacturing specification. Additional paste 135 is a paste added for reducing a viscosity, and the viscosity of additional paste 135 is lower than that of conductive paste 105 to be added.

Fig. 13B is a sectional view showing a state in which additional paste 135 whose viscosity is lower than that of conductive paste 105 is added to conductive paste 105 whose viscosity is higher than the normal value. Added paste 136 is a paste obtained by adding additional paste 135 whose viscosity is lower than the normal value to conductive paste 105 whose viscosity becomes higher than the normal value in the manufacturing specification. A viscosity range of added paste 136 is in a range of the normalized value in the manufacturing specification through the addition of additional paste 135. With the addition of additional paste 135, not only the viscosity range but also the composition ratio of the paste can be put into the normal value in the manufacturing specification.

Fig. 13C is a schematic view for illustrating a problem generated due to added paste 136.

As shown in Fig. 13C, when added paste 136 is filled in first hole 103 formed in first prepreg 101, unfilled portion 137 or air gap 138 may be generated. This is thought to be because a large number of fiber pieces 108 are mixed in added paste 136 as shown in Fig. 13C. Even if additional paste 135 is simply added, it is impossible to exclude the influence of fiber pieces 108 mixed in conductive paste 105.

Furthermore, when the viscosity of the conductive paste before printing is 15 (Pa.s), the viscosity after 250 sheets are printed is about 89 (Pa.s) (see the below-mentioned Table 1). Only when a new conductive paste is added without adjusting the viscosity of the conductive paste, after 250 sheets are printed, the viscosity becomes higher than 50 (Pa.s). When the viscosity is high, a filling property into first hole 103 may be influenced. When the initial viscosity of the reuse paste is more than 50 Pa·s, the number of sheets to be able to be printed thereafter may be reduced. Therefore, it is preferable that the viscosity before the start of printing is adjusted to be not less than 5 (Pa.s) and not more than 50 (Pa.s). That is to say, in this exemplary embodiment, it is important to adjust the viscosity of the used conductive paste and to filter the used conductive paste by using a filter.

Hereinafter, reuse according to this exemplary embodiment is described. The present invention proposes not simple reuse of a used conductive paste but any of highly advanced technical ideas utilizing a natural law for reuse. It is thought that decrease in an amount of discard of conductive pastes, and furthermore, the reuse of the conductive pastes in the present invention correspond to reuse, which is reuse with the same purpose as that in the beginning, including continuous use in EU (for example, in WEE (Waste Electrical and Electronic Equipment) Directive, Article 7).

In particular, in EU (for example, WEE Directive, Article 7), recycle is divided into two categories, that is, recovery and disposal. Furthermore, the recovery is divided into three categories, that is, reuse, recycle and energy recovery. Herein, the disposal denotes redemption or landfill. The reuse denotes that use is carried out again for the same purpose as that in the beginning including the continuous use. The recycle denotes reprocessing of a waste material for the purpose in the beginning or the other purpose in the production process. The energy recovery denotes energy recovery through direct combustion accompanied by thermal recovery.

This exemplary embodiment corresponds to the recovery in the definition of the recycle in EU and is useful for reduction in waste or the like or reduction in consumption of resource energy or the like.

Even if a conductive paste is simply mixed into a used conductive paste (or conductive paste being used) on a metal mask having a smaller opening portion than that of a material to be printed, fiber pieces or the like to be mixed (further stored) in the conductive paste cannot be removed. Therefore, the used conductive paste (or the conductive paste to be used for reuse) according to this exemplary embodiment is recovered to an outside of a printing machine through the metal mask or the like provided in the periphery of the material to be printed.

In this exemplary embodiment, the used conductive paste is taken out (or recovered) from the metal mask or the like (and furthermore, a used printing machine, squeegee or the like) provided in the vicinity of the material to be printed, and the conductive paste is recycled (particularly, reused) in the outside of the printing machine (or in another place, another device). When the used conductive paste is taken out in this way, the used conductive pastes generated in a plurality of different print lots on different days and times are efficiently recovered and are thus gathered into a single large lot (not less than 1 kg, not less than 5 kg, and furthermore, not less than 10 kg). Therefore, efficiency or yield of recycle (particularly, reuse) of the conductive paste can be enhanced. An amount of the used conductive paste generated after printing is completed is small (for example, less than 1 kg, and further 500 g to 50 g). When printing is carried out by using a squeegee, when the amount of the conductive paste is decreased, the conductive paste is scattered discontinuously on the linear contact surface of the squeegee and the material to be printed, and cannot be filled in the holes formed in the prepreg. By gathering a plurality of the conductive pastes in small amounts to increase the amount (not less than 1 kg and further not less than 10 kg) rather than recovering them in a small amounts, the fiber pieces or the like in the used paste can be removed with a high efficiency.

In this exemplary embodiment, recovered conductive pastes are reproduced such that they can be reused with a dispersion state of conductive particles maintained as it is. Thus, this exemplary embodiment proposes a highly advanced technical idea.

Hereinafter, this exemplary embodiment is described in more detail. Tables 1 to 5 show an example of the result obtained by an experiment for the effects in this exemplary embodiment.

Tables 1 to 5 show diameters and the number of the holes formed in the prepreg, and defect rates when the number of printed sheets is varied. Furthermore, a right end of each Table shows a viscosity for each number of printed sheets. By using a cone-plate type rheometer, an apparent viscosity at 0.5 rpm is measured. A unit of the viscosity is Pa·s. The cone of the cone-plate type rheometer has a diameter of 25 mm and a cone angle of 2°. A measurement temperature of the sample is 25°C. Measurement of viscosity or the like is based on JIS K7117-2.

Prepreg (500 mm × 600 mm) is provided with 50000 holes in total including 10000 holes each having a diameter of 80 µm, 10000 holes each having a diameter of 100 µm, 10000 holes each having a diameter of 130 µm, 10000 holes each having a diameter of 150 µm, and 10000 holes each having a diameter of 200 µm. Table 1 shows the results obtained by evaluating them using a test pattern capable of carrying out evaluation in a single prepreg. As the conductive paste, paste obtained by kneading spherical copper powder having a center particle diameter of 7 µ, epoxy resin and a latent curing agent having a particle diameter of 15 µ by using three-roller is used. In the Table 1, the number of vias which have conduction defect is measured in 10000 holes. Note here that generally widely used via chain pattern, that is, a test pattern for measuring whether or not one disconnected via is present in 10000 continuous vias is not used. Furthermore, when 10000 holes each having a diameter of 130 µm are formed, a yield obtained when 350 sheets are printed is set to be 1.0 as normalization. For this reason, a unit is not given to the defect rate in the Table 1. In Table 1, φ represents a diameter of a hole.

**[Table 1]**

| Number of printed sheets (sheets) | φ80 µm ×10000 holes | φ100 µm ×10000 holes | φ130 µm ×10000 holes | φ150 µm ×10000 holes | φ200 µm ×10000 holes | viscosity (Pa·s) |
|---|---|---|---|---|---|---|
| 0 | - | - | - | - | - | 15 |
| 50 | 0 | 0 | 0 | 0 | 0 | 20 |
| 100 | 0 | 0 | 0 | 0 | 0 | 32 |
| 150 | 0 | 0 | 0 | 0 | 0 | 42 |
| 200 | 0 | 0 | 0 | 0 | 0 | 69 |
| 250 | 0 | 0 | 0 | 0 | 0 | 89 |
| 300 | 7.5 | 1.7 | 0 | 0 | 0 | 137 |
| 350 | 14.5 | 5.8 | 1.0 (normalized value) | 0 | 0 | 169 |
| 400 | 33.2 | 9.9 | 3.8 | 1.2 | 0 | 247 |
| 450 | 63.9 | 21.4 | 10.3 | 3.8 | 0.9 | 511 |

From the result of the 50th printed sheet in Table 1, a defect does not occur in the case of the holes having the diameters of 80 µm to 200 µm. The viscosity at this time is 20 (Pa.s).

From the result of the 250th printed sheet in Table 1, a defect does not occur in the case of the holes having the diameters of 80 µm to 200 µm. The viscosity at this time is 89 (Pa.s). It is shown that the viscosity is increased as the number of printed sheets is increased.

From the result of the 300th printed sheet in Table 1, the defect rate is 7.5 in the case of the holes having a diameter of 80 µm, and the defect rate is 1.7 in the case of the holes having a diameter of 100 µm. The defect does not occur in the case of the holes having diameters of 130 to 200 µm. As mentioned above, it is shown that when the number of the printed sheets is increased to 300, the defect rate is increased as the diameter of the hole is decreased. Furthermore, the viscosity at the time when the number of printed sheets is 300 is 137 (Pa.s), and the defect does not occur for the 300th sheet in the case of the holes having the diameters of 130 to 200 µm. The defect occurs when the diameter of the hole is not more than 100 µm, and the defect does not occur when the diameter of the hole is not less than 130 µm. This is thought to be as follows. Since the holes each having a diameter of 130 to 200 µm have larger diameters as compared with the holes having diameters of 80 to 100 µm, even when the viscosity of the conductive paste is increased to 137 (Pa.s), the conductive paste can be filled in the hole reliably.

From the result when the number of printed sheets is 350 in Table 1, the defect rate is 14.5 for 10000 holes each having a diameter of 80 µm, 5.8 for 10000 holes each having a diameter of 100 µm, and 1.0 for 10000 holes each having a diameter of 130 µm (because this value is normalized as 1.0). Note here that the defect rate is 0 for holes having diameters of 150 µm and 200 µm. This is thought to be as follows. Although the viscosity of the paste is further increased to 169 (Pa.s), the diameter of the hole is large, that is, not less than 150 µm, so that conductive pastes can be filled in the holes reliably.

From the result when the number of printed sheets is 400 in Table 1, the defect rate is 33.2 for 10000 holes each having a diameter of 80 µm, 9.9 for 10000 holes each having a diameter of 100 µm, 3.8 for 10000 holes each having a diameter of 130 µm, and 1.2 for 10000 holes each having a diameter of 150 µm. Note here that the defect rate is 0 for holes each having a diameter of 200 µm. This is thought to be as follows. Although the viscosity of the paste is further increased to 247 (Pa.s), the diameter of the hole is large, that is, 200 µm, so that conductive pastes can be filled in the holes reliably.

From the result when the number of printed sheets is 450 in Table 1, the defect rate is 63.9 for 10000 holes each having a diameter of 80 µm, 21.4 for 10000 holes each having a diameter of 100 µm, 10.3 for 10000 holes each having a diameter of 130, 3.8 for 10000 holes each having a diameter of 150 µm, and 0.9 for 10000 holes each having a diameter of 200 µm. Note here that a defect occurs even when the diameter of the hole is 200 µm. This is thought to be because when as many as 450 sheets are printed, a viscosity of ink is largely increased to 511 (Pa.s), so that the conductive paste cannot be filled in the holes although a diameter of each hole is large, that is, 200 µm.

When the diameter of the hole is smaller than 130 µm, a defect does not occur when the viscosity of the conductive paste is 89 (Pa.s), but a defect occurs when the viscosity of the conductive paste is 137 (Pa·s). Therefore, it is desirable that when the viscosity of the conductive paste is not less than about 80 (Pa.s), the conductive pastes which have not been filled in the holes should be recovered as the recovery paste. Since the initial viscosity (the viscosity before the start of printing) of the conductive paste is 15 (Pa.s), when the viscosity becomes not less than about 5 times as large as the initial viscosity, the conductive pastes which have not been filled in the holes may be recovered as the recovery paste.

When the diameter of the hole is not less than 130 µm and less than 150 µm, a defect does not occur when the viscosity of the conductive paste is 137 (Pa.s), but a defect occurs when the viscosity of the conductive paste is 169 (Pa.s). Therefore, it is desirable that when the viscosity of the conductive paste is not less than about 130 (Pa.s), the conductive pastes which have not been filled in the holes should be recovered as the recovery paste. Since the initial viscosity of the conductive paste is 15 (Pa.s), when the viscosity becomes not less than about 8 times as large as the initial viscosity, the conductive pastes which have not been filled in the holes may be recovered as the recovery paste.

When the diameter of the hole is not less than 150 µm and less than 200 µm, a defect does not occur when the viscosity of the conductive paste is 169 (Pa.s), but a defect occurs when the viscosity of the conductive paste is 247 (Pa.s). Therefore, it is desirable that when the viscosity of the conductive paste is not less than about 160 (Pa.s), the conductive pastes which have not been filled in the holes should be recovered as the recovery paste. Since the initial viscosity of the conductive paste is 15 (Pa.s), when the viscosity becomes not less than about 10 times as large as the initial viscosity, the conductive pastes which have not been filled in the holes may be recovered as the recovery paste.

When the diameter of the hole is not less than 200 µm, a defect does not occur when the viscosity of the conductive paste is 247 (Pa.s), but a defect occurs when the viscosity of the conductive paste is 511 (Pa·s). Therefore, it is desirable that when the viscosity of the conductive paste is not less than about 240 (Pa.s), the conductive pastes which have not been filled in the holes should be recovered as the recovery paste. Since the initial viscosity of the conductive paste is 15 (Pa.s), when the viscosity becomes not less than about 16 times as large as the initial viscosity, the conductive pastes which have not been filled in the holes may be recovered as the recovery paste.

It may be difficult to precisely obtain measurement values of the viscosity in processes every measurement time. In such a case, it is useful to measure what times the viscosity after printing is as large as the initial viscosity where the initial viscosity (before start of printing) is defined as 1, and to recover the conductive pastes which have not been filled in the hole as a recovery paste. Herein, the viscosity before the start of printing is defined as 1, but the viscosity after predetermined number of sheets (for example, ten sheets) are printed may be defined as 1.

Furthermore, as shown in Table 1, relation between the viscosity and the number of printed sheets at which a defect occurs is previously examined, and the conductive pastes which have not been filled in the hole after a predetermined number of sheets are printed may be recovered as the recovery paste.

Note here that the diameter of the hole of 80 µm means in detail the diameter of 80 µm ± 8 µm. The diameter of the hole of 100 µm means in detail the diameter of 100 µm ± 10 µm. The diameter of the hole of 130 µm means in detail the diameter of 130 µm ± 13 µm. The diameter of the hole of 150 µm means in detail the diameter of 150 µm ± 15 µm. The diameter of the hole of 200 µm means in detail the diameter of 200 µm ± 20 µm. This is because variation occurs in the diameters of the holes. Note here that it is useful that the diameter of the hole is a diameter in the portion whose sectional area is a minimum.

Conventionally, when the number of printed sheets is a predetermined number or more, conductive pastes are discarded regardless of a diameter of a hole. A used conductive paste may cause defects in a small hole whose diameter is 80 µm, but defects may not occur in a relatively large hole whose diameter is 200 µm. Conventionally, however, a conductive paste that can be used by selecting a diameter of a hole may be discarded in many cases.

In this exemplary embodiment, conductive pastes exceeding the number of the printed sheets, that is, 450 in the Table 1 which are conventionally discarded are recovered as recovery pastes 119a to 119d. Furthermore, the used conductive pastes are united with used conductive pastes in other lots so as to prepare about 10 kg of recovered composite pastes 120. Viscosities of individual recovery pastes 119a to 119d are largely varied from about 600 to 800 (Pa.s).

Then, in order to remove fiber pieces 108 formed of a glass fiber having a length of not less than 100 µm and mixed in recovered composite paste 120, filtration using 100-mesh filter 121 is carried out as shown in Fig. 7 to obtain filtered recovery paste 122. Thus, the aggregated conductive powder or an aggregate of the latent curing agent is disentangled.

Thereafter, the viscosity is adjusted as shown in Fig. 8. Furthermore, by using, for example, thermogravimetric analysis (TG), the degree of composition deviation in the conductive paste is measured and the viscosity is adjusted with respect to the composition deviation by adding solvent 123 or the like. Then, this is defined as a first-time reproduced reuse paste, and is subjected to the same printing experiment as in Table 1. The results are shown in Table 2. In Table 2, for example, the description of the number of printed sheets of 450 + 50 = 500 sheets in the first line means that 50 sheets are printed as the first-time reuse paste. That is to say, it means that even when 50 sheets are newly printed as the first-time reuse paste, 450 sheets have been printed previously (that is to say, at the time when it is brand-new). Printing of 50 sheets with the first-time reused paste corresponds to printing of 50 + 450 = 500 sheets in total.

**[Table 2]**

| Number of printed sheets (sheets) | φ80 µm ×10000 holes | φ100 µm ×10000 holes | φ130 µm ×10000 holes | φ150 µm ×10000 holes | φ200 µm ×10000 holes | viscosity (Pa·s) |
|---|---|---|---|---|---|---|
| After adjustment of viscosity | - | - | - | - | - | 20 |
| 450+50=500 | 0 | 0 | 0 | 0 | 0 | 29 |
| 450+100=550 | 0 | 0 | 0 | 0 | 0 | 51 |
| 450+150=600 | 0 | 0 | 0 | 0 | 0 | 74 |
| 450+200=650 | 0 | 0 | 0 | 0 | 0 | 100 |
| 450+250=700 | 6.5 | 1.2 | 0 | 0 | 0 | 125 |
| 450+300=750 | 20.0 | 10.5 | 1.6 | 0.1 | 0 | 212 |
| 450+350=800 | 33.3 | 16.5 | 7.9 | 1.6 | 0.1 | 345 |
| 450+400=850 | 66.7 | 30.6 | 21.3 | 12.5 | 1.2 | 500 |
| 450+450=900 | 200.0 | 76.7 | 36.5 | 14.1 | 2.3 | 714 |

The following is a description of a column of the number of printed sheets of 450 (the number of printed sheets in a brand-new product) + 200 (the number of printed sheets as a reuse paste) = 650 (the total number of printed sheets) in Table 2. Even in a first-time reused reuse conductive paste, a defect does not occur until the number of the printed sheets is 200 when the holes having the diameters of 80 µm to 200 µm are used. In the first-time reused reuse paste, the number of the printed sheets of 200 corresponds to that 650 sheets are actually printed because 450 sheets have already been printed at the time of a brand-new product.

In the case of the hole having the diameter of 80 µm, the defect rate is 63.9 when the number of printed sheets is 450 in Table 1, but the defect rate is 0 when the number of printed sheets is 450 + 200 = 650 in Table 2. Thus, in this exemplary embodiment, even when a small diameter of 80 µm in which the defect rate tends to be increased is used and the number of printed sheets is increased, the defect rate can be drastically reduced.

The following is a description of a column of the number of printed sheets 450 (the number of printed sheets in a brand-new product) + 400 (the number of printed sheets as a reuse paste) = 850 (the total number of printed sheets) in Table 2. In a first-time reused reuse paste, when the number of printed sheets is 400 sheets, the defect rate is 66.7 for the hole having the diameter of 80 µm, 30.6 for the hole having the diameter of 100 µm, 21.3 for the hole having the diameter of 130 µm, 12.5 for the hole having the diameter of 150 µm, and 1.2 for the hole having the diameter of 200 µm. Also in a reused paste, it is shown that as the number of the printed sheets is increased, the defect rate is increased particularly when the diameter of the hole is small.

In Table 2, the viscosity of the reuse paste is adjusted to be not less than 5 (Pa.s) and not more than 50 (Pa.s). When the viscosity of the reuse paste is less than 5 (Pa.s), a solid part is lowered, which may influence the via resistance. Furthermore, when the viscosity is high, the filling property in the via may be influenced. When the initial viscosity of the reuse paste is more than 50 Pa.s, the number of sheets that can be printed thereafter is reduced. Therefore, it is preferable that the viscosity before the start of printing is adjusted to not less than 5 (Pa.s) and not more than 50 (Pa.s). The viscosity of the reuse paste is made to be not less than 5 (Pa.s) and not more than 50 (Pa.s), and furthermore, the solid part thereof is also desirably adjusted to the range of not more than the solid part (for example, not less than 85 wt% and 95 wt%) ±1 wt.% of the brand-new conductive paste.

When the hole diameter is less than 130 µm, a defect does not occur when the viscosity of the conductive paste is 100 (Pa.s), but a defect occurs when the viscosity is 125 (Pa.s). Therefore, it is desirable that conductive pastes which have not been filled in the holes should be recovered as a recovery paste when the viscosity of the conductive paste is not less than about 100 (Pa.s). Since the viscosity of the conductive paste before the start of printing of the reuse paste is 20 (Pa.s), conductive pastes which have not been filled in the holes may be recovered as a recovery paste when the viscosity is not less than about 5 times as high as the viscosity before the start of printing of the reuse paste.

When the hole diameter is not less than 130 µm and less than 200 µm, a defect does not occur when the viscosity of the conductive paste is 125 (Pa.s), but a defect occurs when the viscosity is 212 (Pa.s). Therefore, it is desirable that conductive pastes which have not been filled in the holes should be recovered as a recovery paste when the viscosity of the conductive paste is not less than about 120 (Pa.s). Since the viscosity of the conductive paste before the start of printing of the reuse paste is 20 (Pa.s), conductive pastes which have not been filled in the holes may be recovered as a recovery paste when the viscosity is not less than about 6 times as high as the viscosity before the start of printing of the reuse paste.

When the hole diameter is not less than 200 µm, a defect does not occur when the viscosity of the conductive paste is 212 (Pa·s), but a defect occurs when the viscosity is 345 (Pa·s). Therefore, it is desirable that conductive pastes which have not been filled in the holes should be recovered as a recovery paste when the viscosity of the conductive paste is not less than about 200 (Pa.s). Since the viscosity of the conductive paste before the start of printing of the reuse paste is 20 (Pa.s), conductive pastes which have not been filled in the holes may be recovered as a recovery paste when the viscosity is not less than about 10 times as high as the viscosity before the start of printing of the reuse paste.

It may be difficult to precisely obtain measurement values of the viscosity in processes every measurement time. In such a case, it is useful to measure what times the viscosity after printing is as large as a viscosity before start of printing is defined as 1, and to recover the conductive pastes which have not been filled in the hole as a recovery paste. Herein, the viscosity before start of printing is defined as 1, but the viscosity after predetermined number of sheets (for example, ten sheets) are printed may be defined as 1.

Furthermore, as shown in Table 2, relation between the viscosity and the number of printed sheets at which a defect occurs is previously examined, and the conductive pastes which have not been filled in the hole after a predetermined number of sheets are printed may be recovered as the recovery paste.

However, since the results shown in Table 2 are obtained after 450 sheets have already been printed in the brand-new product, it is shown that the number of printed sheets is increased to twice as many as that in Table 1.

The following is a description of a column of the number of printed sheets of 450 (the number of printed sheets in the brand-new product) + 450 (the number of printed sheets as the reuse paste) = 900 (the total number of printed sheets) in the Table 2. Even with the first-time reused reuse paste, after 450 sheets (900 sheets in total) are printed, the defect rate is increased.

Therefore, the conductive paste with which 900 sheets are printed in total is formed into recovered composite paste 120 as shown in Fig. 6, and recovered composite paste 120 is filtered by using filter 121 having 100 meshes as shown in FIG. 7 in order to remove fiber piece 108. Thus, filtered recovery paste 122 is obtained. Thereafter, the viscosity is adjusted as shown in Fig. 8. Furthermore, the degree of composition deviation in the conductive paste is measured by using the thermogravimetry (TG) or the like, and the viscosity is adjusted by adding solvent 123 or the like into composition deviation. This is defined as a second-time reproduced reuse paste. The printing experiment as in Table 1 is carried out by using the second-time reused reuse paste. The results thereof are shown in Table 3.

**[Table 3]**

| Number of printed sheets (sheets) | φ80 µm ×10000 holes | φ100 µm ×10000 holes | φ130 µm ×10000 holes | φ150 µm ×10000 holes | φ200 µm ×10000 holes | viscosity (Pa·s) |
|---|---|---|---|---|---|---|
| After adjustment of viscosity | - | - | - | - | - | 35 |
| 900+50=950 | 0 | 0 | 0 | 0 | 0 | 51 |
| 900+100=1000 | 0 | 0 | 0 | 0 | 0 | 69 |
| 900+150=1050 | 0 | 0 | 0 | 0 | 0 | 110 |
| 900+200=1100 | 4.6 | 0.7 | 0 | 0 | 0 | 158 |
| 900+250=1150 | 12.5 | 9.4 | 2.7 | 0.7 | 0 | 215 |
| 900+300=1200 | 30.6 | 21.2 | 7.3 | 4.5 | 0.2 | 348 |
| 900+350=1250 | 82.7 | 56.5 | 17.8 | 11.6 | 1.2 | 501 |
| 900+400=1300 | 273.7 | 160.7 | 39.9 | 19.9 | 2.3 | 811 |
| 900+450=1350 | 650.5 | 283.4 | 69.9 | 58.1 | 3.2 | Not measurable |

The following is a description of a column of the number of the printed sheets of 900 (the number of printed sheets in a brand-new product + the number of printed sheets as the first-time reproduced reuse paste) + 150 (the number of printed sheets as the second-time reproduced reuse paste) = 1050 (the total number of printed sheets) in Table 3. Even with the second-time reused reuse paste, a defect does not occur until the number of printed sheets is 150 when the hole having a diameter of 80 µm to 200 µm is used. The number of the printed sheets of 150 with the second-time reproduced reuse paste corresponds to that 1050 sheets are actually printed because 450 printed sheets are completed at the time of a brand-new product as 450 printed sheets of first-time reproduced reuse paste.

As mentioned above, it is shown that the concoctive pastes with a defect rate generated according to the increase in the number of printed sheets can be repeatedly used for manufacturing a printed circuit board by repeating reproduction processes as shown in Figs. 6 to 8.

When the hole diameter is smaller than 130 µm, a defect does not occur when the viscosity of the conductive paste is 110 (Pa·s), but a defect occurs when the viscosity is 158 (Pa.s). Therefore, it is desirable that the conductive pastes which have not been filled in the holes should be recovered as a recovery paste when the viscosity of the conductive paste is not less than about 110 (Pa.s). Since the viscosity of the conductive paste before the start of printing of the second-time reused reuse paste is 35 (Pa.s), when the viscosity becomes not less than about three times as high as the viscosity before the start of printing of the second-time reused reuse paste, conductive pastes which have not been filled in the holes may be recovered as the recovery paste.

When the hole diameter is not less than 130 µm and less than 200 µm, a defect does not occur when the viscosity of the conductive paste is 158 (Pa.s), but a defect occurs when the viscosity is 215 (Pa.s). Therefore, it is desirable that the conductive pastes which have not been filled in the holes should be recovered as a recovery paste when the viscosity of the conductive paste is not less than about 150 (Pa.s). Since the viscosity of the conductive paste before the start of printing of the second-time reused reuse paste is 35 (Pa·s), when the viscosity becomes not less than about four times as high as the viscosity before the start of printing of the second-time reused reuse paste, conductive pastes which have not been filled in the holes may be recovered as the recovery paste.

When the hole diameter is not less than 200 µm, a defect does not occur when the viscosity of the conductive paste is 215 (Pa·s), but a defect occurs when the viscosity is 348 (Pa.s). Therefore, it is desirable that the conductive pastes which have not been filled in the holes should be recovered as a recovery paste when the viscosity of the conductive paste is not less than about 210 (Pa.s). Since the viscosity of the conductive paste before the start of printing of the second-time reused reuse paste is 35 (Pa.s), when the viscosity becomes not less than about six times as high as the viscosity before the start of printing of the second-time reused reuse paste, conductive pastes which have not been filled in the holes may be recovered as the recovery paste.

It may be difficult to precisely obtain measurement values of the viscosity in processes every measurement time. In such a case, it is useful to measure what times the viscosity after printing is as large as the viscosity before the start of printing of the second-time reused reuse paste where the viscosity before the start of printing of the second-time reused reuse paste is defined as 1, and to recover the conductive pastes which have not been filled in the hole as a recovery paste. Herein, the viscosity before the start of printing of the second-time reused reuse paste is defined as 1, but the viscosity after predetermined number of sheets (for example, ten sheets) are printed may be defined as 1.

Furthermore, as shown in Table 3, relation between the viscosity and the number of printed sheets at which a defect occurs is previously examined, and the conductive pastes which have not been filled in the hole after a predetermined number of sheets are printed may be recovered as the recovery paste.

Next, a case in which a finer mesh (400 mesh) is used for filter 121 (see Fig. 7) is described with reference to Tables 4 and 5. When the finer mesh is used, it is possible to selectively remove fiber pieces 108 such as glass fiber having a length of not less than 20 to 30 µm.

When the mesh is made to be finer, it is possible to enhance the rate of removing fiber pieces 108 or the like mixed in recovered composite paste 120 (see Fig. 7). However, the filtration time is increased, and the yield by filtration may be deteriorated. Therefore, meshes may be used depending upon purposes.

By combining a plurality of filters 121 having different meshes, clogging can be suppressed. Furthermore, the mesh is not necessarily limited to a net type. Surface-type filtration (surface filtration), depth-type filtration (depth filtration), cake-type filtration (glass fibers accumulated on the surface of the filter is used as a cake, and this cake is used as a filter), or the like, may be used. It is useful that commercially available products are improved for such filtration materials or filtration equipment.

In order to remove fiber pieces 108 mixed in recovered composite paste 120, filtration is carried out by using a 400-mesh filter 121 as shown in Fig. 7 to form filtered recovery paste 122.

Thereafter, the viscosity is adjusted as shown in Fig. 8. Furthermore, by using, for example, thermogravimetric analysis (TG), the degree of composition deviation in the conductive paste is measured and the viscosity is adjusted with respect to the composition deviation by adding solvent 123 or the like. Then, this is defined as a first-time reproduced reuse paste, and is subjected to the same printing experiment as in Table 1. The results are shown in Table 4. In Table 4, for example, the description of the number of printed sheets of 450 + 50 = 500 sheets in the first line means that 50 sheets are printed as the first-time reuse paste. That is to say, it means that even when 50 sheets are newly printed as the first-time reuse paste, 450 sheets have been printed previously (that is to say, at the time when it is a brand-new product). Printing of 50 sheets with the first-time reused paste corresponds to printing of 50 + 450 = 500 sheets in total.

**[Table 4]**

| Number of printed sheets (sheets) | φ80 µm ×10000 holes | φ100 µm ×10000 holes | φ130 µm ×10000 holes | φ150 µm ×10000 holes | φ200 µm ×10000 holes | viscosity (Pa·s) |
|---|---|---|---|---|---|---|
| 450+50=500 | 0 | 0 | 0 | 0 | 0 | 23 |
| 450+100=550 | 0 | 0 | 0 | 0 | 0 | 33 |
| 450+150=600 | 0 | 0 | 0 | 0 | 0 | 42 |
| 450+200=650 | 0 | 0 | 0 | 0 | 0 | 65 |
| 450+250=700 | 0 | 0 | 0 | 0 | 0 | 92 |
| 450+300=750 | 10.1 | 0.7 | 0 | 0 | 0 | 132 |
| 450+350=800 | 13.4 | 4.6 | 1.1 | 0 | 0 | 174 |
| 450+400=850 | 34.1 | 9.9 | 4.6 | 1.6 | 0 | 251 |
| 450+450=900 | 56.1 | 24.3 | 10.9 | 2.6 | 0.5 | 515 |

The following is a description of a column of the number of printed sheets of 450 (the number of printed sheets in a brand-new product) + 250 (the number of printed sheets as a reuse paste through 400-mesh filtration) = 700 (the total number of printed sheets) in the Table 4. A defect does not occur until the number of printed sheets is 250 (the total number of printed sheets of 700) when the hole having the diameter of 80 µm to 200 µm is used. Furthermore, because fine filter 121 having 400 meshes is used for filtration, glass fibers remaining in the reuse paste can be further reduced. Therefore, the increase in the viscosity can be suppressed.

**[Table 5]**

| Number of printed sheets (sheets) | φ80 µm ×10000 holes | φ100 µm ×10000 holes | φ130 µm ×10000 holes | φ150 µm ×10000 holes | φ200 µm ×10000 holes | viscosity (Pa·s) |
|---|---|---|---|---|---|---|
| 900+50=950 | 0 | 0 | 0 | 0 | 0 | 25 |
| 900+100=1000 | 0 | 0 | 0 | 0 | 0 | 35 |
| 900+150=1050 | 0 | 0 | 0 | 0 | 0 | 41 |
| 900+200=1100 | 0 | 0 | 0 | 0 | 0 | 70 |
| 900+250=1150 | 0 | 0 | 0 | 0 | 0 | 98 |
| 900+300=1200 | 7.3 | 0 | 0 | 0 | 0 | 140 |
| 900+350=1250 | 12.7 | 6.3 | 0.7 | 0 | 0 | 180 |
| 900+400=1300 | 29.4 | 12.5 | 5.9 | 0.7 | 0 | 259 |
| 900+450=1350 | 52.6 | 20.7 | 9.8 | 4.0 | 1.3 | 518 |

The following is a description of a column of the number of printed sheets of 900 (the number of printed sheets in a brand-new product + at a first-time reproduction) + 250 (the number of printed sheets as a reuse paste through 400-mesh filtration) = 1150 (the total number of printed sheets) in the Table 5. Even if reproduction is repeated twice, a defect does not occur until the number of printed sheets is 250 (the total number of printed sheets is 1150) when the hole having the diameter of 80 µm to 200 µm is used. Because fine filter 121 having 400 meshes is used for filtration, glass fibers remaining in the reuse paste can be further reduced. Therefore, the increase in the viscosity can be suppressed.

As a curing agent of thermosetting resin, a liquid curing agent of acid anhydride and a catalyst such as imidazole are generally used. However, when a reproduction process is repeated a plurality of times, reaction easily proceeds. Therefore, even if a resin component is supplemented, the viscosity of the reuse paste is extremely higher than the original viscosity. On the contrary, in this exemplary embodiment, a latent curing agent is solid at least from a process of producing conductive paste 105 and applying it to protective film 102 to a process of producing a reuse paste. When a solid latent curing agent is used, the increase in the viscosity can be suppressed, thus enabling stable reuse.

As mentioned above, as shown in this exemplary embodiment, by recycling and further reusing conductive paste 105, waste paste can be reduced.

Furthermore, fiber piece 108 may be fiber piece 108 made of glass constituting first prepreg 101 or second prepreg 125 in many cases. Therefore, an opening diameter of filter 121 used in a filtration process is not less than three times as large as an average particle diameter of metal particles included in the conductive paste, and it is desirable to be as not more than 20 times, furthermore not more than 10 times, and furthermore not more than 5 times as large as an average diameter of the fibers. When the opening diameter of filter 121 is not more than 2 times as large as an average particle diameter of metal particles, clogging of filter 121 easily occurs. Furthermore, when the opening diameter of filter 121 is larger than 30 times as large as an average diameter of fibers, short fiber pieces 108 may not be able to be filtered. The opening diameter of filter 121, the average particle diameter of metal particles, the diameter of fibers, or the like, can be observed and measured by using SEM or the like.

Furthermore, it is desirable that the opening diameter of filter 121 should be not less than two times as large as the particle diameter of the solid latent curing agent. When it is less than two times, the solid latent curing agent may be removed together with a foreign substance and curing of the conductive paste becomes insufficient.

In first prepreg 101 and second prepreg 125, it is useful to differentiate at least one of the thickness of the prepreg itself, or the number or density (weaving method, density, the number of fibers, or the like) of glass fibers or aramid fibers constituting the prepreg. When prepregs having different thicknesses, the numbers or densities of glass fibers or aramid fibers constituting the prepreg are used, various circuit boards can be obtained.

Furthermore, diameters of vias of one prepreg may be one diameter. Alternatively, vias having a plurality of different diameters may be formed in one prepreg.

Note here that in this exemplary embodiment, a protective film in preparing a fiber piece housing paste is referred to as a first protective film, and a protective film in producing a circuit board by using a reuse paste is referred to as second protective film. However, a protective film in preparing a fiber piece housing paste may be referred to as a second protective film, and a protective film in producing a circuit board by using reuse paste may be referred to as a first protective film.

Furthermore, in this exemplary embodiment, a hole formed in the prepreg in preparing the fiber piece housing paste is referred to as a first hole, and a hole formed in the prepreg in producing a circuit board by using the reuse paste is referred to as a second hole. However, a hole formed in the prepreg in preparing the fiber piece housing paste may be referred to as a second hole, and a hole formed in the prepreg in producing the circuit board by using the reuse paste may be referred to as a first hole.

### INDUSTRIAL APPLICABILITY

A method of manufacturing a reuse paste in accordance with this exemplary embodiment can reduce fiber pieces to be mixed in a conductive paste in a circuit board using the conductive paste for connecting layers. As a result, yield can be improved. Furthermore, since conductive paste including fiber pieces mixed therein can be reused, a material cost of the circuit board can be radically reduced and an amount of a waste product can be reduced.

### REFERENCE MARKS IN DRAWINGS

101 first prepreg
102 first protective film
103 first hole
104 jig
105 conductive paste
106 base
107, 107b, 207, 307, 407, 507, 607, 707, 807, 907 arrow
108, 108a, 108b, 108c, 108d fiber piece
109 fiber piece housing paste
110 first copper foil
111 first protruded portion
112 first insulating layer
113 first via
114 first wiring
115 first circuit board
116a, 116b, 116c, 116d composition deviation paste
119a, 119b, 119c, 119d recovery paste
120 recovered composite paste
121 filter
122 filtered recovery paste
123 solvent or the like
124 reuse paste
125 second prepreg
126 second protective film
127 second hole
128 second copper foil
129 second protruded portion
130 second insulating layer
131 second via
132 second wiring
133 second circuit board
134 conductive powder (conductive particle)
135 additional paste
136 added paste
137 unfilled portion
138 air gap

## Claims

1. A method of manufacturing a reuse paste, the method comprising:
preparing a fiber piece housing paste that includes a conductive paste including a conductive particle, resin and a latent curing agent, and a fiber piece dropping off from a prepreg used for manufacturing a circuit board;
producing a filtered recovery paste by filtering the fiber piece housing paste, which remains in a paste state, by using a filter; and
producing a reuse paste by adding at least one of a solvent, resin, and a paste having a different composition from that of the filtered recovery paste into the filtered recovery paste.

2. The method of manufacturing a reuse paste of claim 1,
wherein the latent curing agent has a softening temperature of not less than 80°C and not more than 180°C.

3. The method of manufacturing a reuse paste of claim 1,
wherein the latent curing agent has a particle diameter of not less than 0.5 µm and not more than 30 µm.

4. The method of manufacturing a reuse paste of claim 1,
wherein the latent curing agent is a solid from the preparing of the fiber piece housing paste to the producing of the reuse paste.

5. The method of manufacturing a reuse paste of claim 1,
wherein the latent curing agent is at least one of an amine-based latent curing agent, an amine adduct-based latent curing agent, a hydrazide-based latent curing agent, an imidazole-based latent curing agent, and a dicyandiamide-based latent curing agent.

6. The method of manufacturing a reuse paste of claim 1,
wherein an opening diameter of the filter is not less than three times as large as an average particle diameter of the conductive particles, not more than 20 times as large as an average particle diameter of the fiber pieces, and not less than two times as large as a diameter of the latent curing agent.

7. A reuse paste obtained by a method of manufacturing a reuse paste,
wherein the method comprises: preparing a fiber piece housing paste that includes a conductive paste including a conductive particle, resin and a latent curing agent, and a fiber piece dropping off from a prepreg used for manufacturing a circuit board;
producing a filtered recovery paste by filtering the fiber piece housing paste, which remains in a paste state, by using a filter; and
producing reuse paste by adding at least one of a solvent, resin, and a paste having a different composition from that of the filtered recovery paste into the filtered recovery paste.

8. A method of manufacturing a circuit board, the method comprising:
attaching a first protective film to a surface of a first prepreg;
forming a first hole in the first prepreg through the first protective film;
applying a conductive paste including a conductive particle, resin and a latent curing agent onto the first protective film;
filling a part of the conductive paste into the first hole;
gathering a plurality of the conductive pastes which have not been filled into the first hole for recovering them as a fiber piece housing paste;
producing a filtered recovery paste by filtering the fiber piece housing paste, which remains in a paste state, by using a filter;
producing a reuse paste by adding at least one of a solvent, resin, and a paste having a different composition from that of the filtered recovery paste into the filtered recovery paste;
attaching a second protective film to a surface of a second prepreg;
forming a second hole in the second prepreg through the second protective film;
filling the reuse paste into the second hole;
peeling the second protective film so as to form a protruded portion made of the reuse paste on the surface of the second prepreg;
disposing a metal foil on both surfaces of the second prepreg, and pressurizing the second prepreg from outside of the metal foil;
curing the second prepreg and the reuse paste by heating the second prepreg; and
processing the metal foil into a wiring pattern.

9. The method of manufacturing a circuit board of claim 8,
wherein the latent curing agent has a softening temperature of not less than 80°C and not more than 180°C.

10. The method of manufacturing a circuit board of claim 8,
wherein the latent curing agent has a particle diameter of not less than 0.5 µm and not more than 30 µm.

11. The method of manufacturing a circuit board of claim 8,
wherein the latent curing agent is a solid at least from the applying of the conductive paste to the producing of the reuse paste.

12. The method of manufacturing a circuit board of claim 8,
wherein the latent curing agent is at least one of an amine-based latent curing agent, an amine adduct-based latent curing agent, a hydrazide-based latent curing agent, an imidazole-based latent curing agent, and a dicyandiamide-based latent curing agent.

13. The method of manufacturing a circuit board of claim 8,
wherein an opening diameter of the filter is not less than three times as large as an average particle diameter of the conductive particles, not more than 20 times as large as an average particle diameter of the fiber pieces, and not less than two times as large as a diameter of the latent curing agent.

14. A method of manufacturing a circuit board, the method comprising:
preparing a fiber piece housing paste including a conductive paste that includes a conductive particle, resin, and a latent curing agent, and a fiber piece dropping off from a first prepreg;
producing a filtered recovery paste by filtering the fiber piece housing paste, which remains in a paste state, by using a filter;
producing a reuse paste by adding at least one of a solvent, resin, and a paste having a different composition from that of the filtered recovery paste into the filtered recovery paste;
attaching a second protective film to a surface of a second prepreg;
forming a second hole in the second prepreg through the second protective film;
filling the reuse paste into the second hole;
peeling the second protective film so as to form a protruded portion made of the reuse paste on the surface of the second prepreg;
disposing a metal foil on both surfaces of the second prepreg, and pressurizing the second prepreg from outside of the metal foil;
curing the second prepreg and the reuse paste by heating the second prepreg; and
processing the metal foil into a wiring pattern.

15. The method of manufacturing a circuit board of claim 14,
wherein the latent curing agent has a softening temperature of not less than 80°C and not more than 180°C.

16. The method of manufacturing a circuit board of claim 14,
wherein the latent curing agent has a particle diameter of not less than 0.5 µm and not more than 30 µm.

17. The method of manufacturing a circuit board of claim 14,
wherein the latent curing agent is a solid at least from the preparing of the conductive paste to the producing of the reuse paste.

18. The method of manufacturing a circuit board of claim 14,
wherein the latent curing agent is at least one of an amine-based latent curing agent, an amine adduct-based latent curing agent, a hydrazide-based latent curing agent, an imidazole-based latent curing agent, and a dicyandiamide-based latent curing agent.

19. The method of manufacturing a circuit board of claim 14,
wherein an opening diameter of the filter is not less than three times as large as an average particle diameter of the conductive particles, not more than 20 times as large as an average particle diameter of the fiber pieces, and not less than two times as large as a diameter of the latent curing agent.
